# EUROPEAN PATENT SPECIFICATION

(11) **EP 1 905 787 B1**
(45) Date of publication and mention of the grant of the patent: **18.05.2011**
(21) Application number: 07018799.2
(22) Date of filing: 25.09.2007
(51) Int. Cl.: C08F 20/44, G03F 7/00, B41C 1/10

(54) **Lithographic printing plate precursor using a polymer latex of high acrylonitrile content**
Flachdruckplattenvorläufer unter Verwendung eines Polymerlatex mit hohem Acrylnitrilanteil
Précurseur de plaque d'impression utilisant un latex en polymère riche en acrylonitrile

(30) Priority: 27.09.2006 JP 2006263217; 27.09.2006 JP 2006263359; 27.09.2006 JP 2006263360
(43) Date of publication of application: 02.04.2008
(73) Proprietor: FUJIFILM Corporation, Minato-ku Tokyo (JP)
(72) Inventor: Araki, Katsumi, Haibara-gun Shizuoka (JP); Sonokawa, Koji, Haibara-gun Shizuoka (JP)
(74) Representative: HOFFMANN EITLE

(56) References cited:
- EP-A- 0 590 460
- GB-A- 722 478
- GB-A- 1 294 896
- US-A- 2 635 091
- US-A- 3 112 223
- US-A- 3 161 699
- US-A- 4 072 528
- US-B1- 6 372 411

## Description

### FIELD OF THE INVENTION

The present invention relates to a lithographic printing plate precursor using a polymer latex containing acrylonitrile in a high content.

More particularly, it makes us of a polymer latex of a homopolymer of acrylonitrile or a polymer latex of high acrylonitrile content as a repeating unit which is excellent in a lithographic printing plate precursor prepared from the polymer latex.

### BACKGROUND OF THE INVENTION

An acrylonitrile resin is a thermoplastic resin which exhibits the excellent gas barrier property based on the specific intermolecular bond of the nitrile group and also is excellent in the chemical resistance against an acid, alkali, organic solvent or the like and in the mechanical properties, for example, bending elastic modulus, strength or creep resistance and in recent years, the utility values of the acrylonitrile resin have been recognized as a material for a film, sheet or container as a packaging material in the field, for example, of foods, medicines, agrichemicals or cosmetics.

However, in general, since an acrylonitrile polymer latex has strong cohesion between the polymer particles, when the content of acrylonitrile is high, polymerization stability degrades so that a latex can not be stably obtained. As a technique for stably obtaining a latex of high acrylonitrile content, a production method wherein a certain amount or more of an acid group is introduced into a polymer formed at the polymerization under conditions of a specific pressure and temperature is known (see, for example, JP-B-54-41638 (the term "JP-B" as used herein means an "examined Japanese patent publication") and JP-B-55-2207 (corresponding to US Patent 4,130,525)). However, since the method is required the addition of a copolymerization monomer other than acrylonitrile in order to achieve the dispersion stability, not only the characteristics of polyacrylonitrile per se degrades but also a manufacturing equipment, for example, an autoclave is necessary, and thus a simple production method has not been known.

Further, besides the above, a latex of a polymer containing acrylonitrile is known (see, for example, JP-A-2000-319415 (the term "JP-A" as used herein means an "unexamined published Japanese patent application"). JP-A-59-213773 (corresponding to US Patent 4,510,204), JP-A-57-195770 (corresponding to US Patent 4,374,948) and U.S. Patent 4,414,063 and J. Chem. Soc., Faraday Trans., 1, 1986, 82, 943-952, Journal of Polymer Science: Part A-1, Vol. 5, 455-468 (1967) and Journal of Polymer Science: Part A-1, Vol. 5, 469-480 (1967)). However, all of the reports relate to latexes of acrylonitrile copolymer including some sort of copolymerization monomer for the purpose of dispersion stability, and thus a latex of a homopolymer of acrylonitrile has not been known at all.

Also, since polymerizability of acrylonitrile is ordinarily not high in an emulsion polymerization, an unreacted remaining monomer remains after the polymerization and the situation of scattering of acrylonitrile which is harmful to humans can not be ever avoided (see, for example, JP-B-55-2207 (corresponding to US Patent 4,130,525)).

In response, a method of removing the remaining monomer from the acrylonitrile copolymer by azeotropy with methanol has been reported (see, for example, U.S. Patent 4,414,063). However, since the method must be used other azeotropic solvent, the production cost increases and methanol is harmful to humans, and thus a method of high environment safety has not yet been proposed.

Further, with respect to the homopolymer of acrylonitrile the removal of the remaining monomer has not been known at all.

On the other hand, in the field of lithographic printing, simplification of operation and realization of dry system and non-processing system have been strongly required from both aspects of efficiency and consideration for global environment on the plate-making operation. From the standpoint of the efficiency, a computer-to-plate (CTP) technique of carrying digitalized image information on highly converging radiation, for example, laser light and conducting scanning exposure of a lithographic printing plate precursor with the light thereby directly preparing a lithographic printing plate without using a lith film becomes widespread. Also, in view of the consideration for global environment, a plate-making system eliminating a conventional wet processing carrying out using a developer after exposure, for example, on-machinc development has been developed. The on-machine development is a system of plate-making wherein a lithographic printing plate precursor is brought into contact with printing ink and/or dampening water on a printing machine to remove the unexposed area in the lithographic printing plate precursor. As the lithographic printing plate precursor responding to the requirements from both aspects of the digitization and the consideration for global environment, a lithographic printing plate precursor having a light- and or heat-polymerizable image-recording layer is known.

In such a lithographic printing plate precursor, a protective layer for the purpose of blocking oxygen which hinders the light- and or heat-polymerixation reaction is provided on the image-recording layer. As a material of the protective layer, polyvinyl alcohol, polyvinyl pyrrolidone, polyvinylimidazole, a water-soluble acrylic resin, for example, polyacrylic acid, gelatin, gum arabic, a cellulose polymer, for example, carboxymethylcellulose and those including mica are know (see, for example, JP-A-9-160226, JP-A-2001-171250 and JP-A-2005-119273 (US 2005/0069811 A1)). However, in the case of using such a material, any one or more of plate-making performances or printing performances, for example, oxygen blocking property, printing durability, ink-receptive property in the initial stage of printing, ink-receptive property during printing, development property, on-machine development property or scratch resistance may be deteriorated in some cases. In particular, although the protective layer of a water soluble polymer, for example, polyvinyl alcohol, polyvinyl pyrrolidone, polyacrylic acid or a cellulose polymer or those including mica exhibits the extremely good oxygen blocking property, the development property, ink-receptive property, printing durability or the like decreases in many cases and thus, the improvement is one of the important technical subjects.

### SUMMARY OF THE INVENTION

The present invention intends to solve the above-described problems in the prior art and an object of the invention is to provide a lithographic printing plate precursor which is capable of forming efficiently an image upon laser exposure and is excellent in the printing durability, ink-receptive property and on-machine development property, and a lithographic printing method using the same.

Polymerization of acrylonitrile can be performed stably and in high acrylonitrile content by emulsion polymerization under the specific conditions, for example, an initiator, a protective colloid, monomer concentration, polymerization temperature or polymerization time and a latex of an acrylonitrile homopolymer or a copolymer of high acrylonitrile content which does not contain a remaining monomer at all obtaining a film or the like having high acrylonitrile content. Specifically, the invention includes the following items.
(1) A lithographic printing plate precursor comprising a protective layer containing as a main component, a polymer containing as a repeating unit, acrylonitrile_{,}
   wherein the polymer contains as the repeating unit, 90% by mole or more of acrylonitrile.
(2) The lithographic printing plate precursor as described in (1) above, wherein the polymer is a latex.
(3) The lithographic printing plate precursor as described in (2) above, wherein the protective layer is prepared by coating the latex.
(4) The lithographic printing plate precursor as described in (2) or (3) above, wherein an average particle size of the latex is 3 µm or less.
(5) The lithographic printing plate precursor as described in any one of (1) or (4) above, wherein the protective layer contains mica.
(6) The lithographic printing plate precursor as described in any one of (1) or (5) above which comprises an image-recording layer containing (A) a radical generator, (B) a sensitizing dye and (c) a compound having at least one addition-polymerizable ethylenically unsaturated bond.
(7) The lithographic printing plate precursor as described in (6) above, wherein the sensitizing dye (B) is an infrared absorbing agent.
(8) The lithographic printing plate precursor as described in (6) or (7) above, wherein the image-recording layer is a layer capable of being removed with printing ink and/or dampening water (fountain solution).
(9) The lithographic printing plate precursor as described in any one (6) or (8) above, wherein the image-recording layer further contains (D) a binder polymer.
(10) The lithographic printing plate precursor as described in any one (6) or (9) above, wherein the image-recording layer further contains (E) a microcapsule or microgel.
(11) The lithographic printing plate precursor as described in any one (6) or (10) above which has an image-recording layer capable of being image-recorded with infrared laser exposure on a support and which is capable of performing printing by conducting image-recording with an infrared laser and then mounting on a printing machine without carrying out a development processing step or by mounting on a printing machine and then conducting image-recording with an infrared laser.
(12) A lithographic printing method comprising a step of exposing imagewise the lithographic printing plate precursor as described in any one (6) or (11) above with an infrared laser and a printing step by supplying oily ink and an aqueous component to perform printing without carrying out any development processing of the exposed lithographic printing plate precursor, wherein an unexposed area of the lithographic printing plate precursor to the infrared laser is removed in the course of the printing step.

By using a protective layer including a polymer containing acrylonitrile as a repeating unit, it is possible to provide a good pattern forming material, particularly, a lithographic printing plate precursor excellent in the printing durability, ink-receptive property and on-machine (on-press) development property.

### DETAILED DESCRIPTION OF THE INVENTION

### The present invention will be described in more detail below.

### [Polymer latex]

In the polymer latex used in the invention, acrylonitrile accounts for 70% by weight or more of the total polymerization component of the polymer. The content of acrylonitrile is desirably from 80 to 100% by weight, particularly preferably 95% by weight or more, and most preferably 100% by weight. The amount of one or more vinyl monomers copolymerizable with acrylonitrile is from 0 to 30% by weight, desirably from 0 to 20% by weight, and particularly desirably from 0 to 5% by weight. When the content of acrylonitrile is less than 70% by weight, the gas barrier property, the chemical resistance against an acid, alkali, organic solvent or the like and the mechanical properties, for example, bending elastic modulus, strength or creep resistance are not sufficiently obtained on a film prepared by coating the latex.

The vinyl monomer copolymerizable with acrylonitrile used in the invention is not particularly restricted and known or well known compounds having a carbon-carbon unsaturated double bond are usefully employed.

For instance, monomers used in methacrylic acid copolymers, acrylic acid copolymers, itaconic acid copolymers, crotonic acid copolymers, maleic acid copolymers, maleic anhydride copolymers, partially esterified maleic acid copolymers and partially amidated maleic acid copolymers as described in JP-A-59-44615, JP-B-54-34327, JP-B-58-12577, JP-B-54-25957, JP-A-59-53836 and JP-A-59-71048, (meth)acrylates, (meth)acrylamides, aromatic hydrocarbon rings including a vinyl group, heteroaromatic rings including a vinyl group, maleic anhydride, itaconates, crotonates, (meth)acrylonitrile, (meth)crotonitile, various styrenes, various benzoyloxyethylenes, various acetoxyethylene, vinyl carbazoles and vinyl pyrrolidone are exemplified.

Of the monomers, (meth)acrylic acid, an alkyl or cycloalkyl (meth)acrylate having from 1 to 25 carbon atoms which may have a substituent, a (meth)acrylate including a bicycle ring and having from 1 to 25 , carbon atoms which may have a substituent, an aralkyl (meth)acrylate having from 1 to 25 carbon atoms which may have a substituent, an aryl (meth)acrylate having from 1 to 25 carbon atoms which may have a substituent, (meth)acrylamide, a secondary or tertiary, alkyl or cycloallcyl(meth)acrylamide having from 1 to 25 carbon atoms which may have a substituent, a secondary or tertiary (meth)acrylamide including a bicycle ring and having from 1 to 25 carbon atoms which may have a substituent, a secondary or tertiary aralkyl (meth)acrylamide having from 1 to 25 carbon atoms which may have a substituent, a secondary or tertiary aryl (meth)acrylamide having from 1 to 25 carbon atoms which may have a substituent, (meth)acryloyl morpholine having from 1 to 25 carbon atoms which may have a substituent,
a substituted or unsubstituted aromatic hydrocarbon ring including a vinyl group and having from 1 to 25 carbon atoms, a substituted or unsubstituted heteroaromatic ring including a vinyl group and having from 1 to 25 carbon atoms, maleic anhydride, a substituted or unsubstituted (a-methyl)styrene having from 1 to 25 carbon atoms, vinyl imidazole, vinyl triazole, maleic anhydride, a substituted or unsubstituted partially esterified maleic acid having from I to 25 carbon atoms, a substituted or unsubstituted partially amidated maleic acid having from 1 to 25 carbon atoms, methyl jasmonate,
itaconic acid, an alkyl or cycloalkyl itaconate having from 1 to 25 carbon atoms which may have a substituent, an itaconate including a bicycle ring and having from 1 to 25 carbon atoms which may have a substituent, an aralkyl itaconate having from 1 to 25 carbon atoms which may have a substituent, an aryl itaconate having from 1 to 25 carbon atoms which may have a substituent,
crotonic acid, an alkyl or cycloalkyl crotonate having from 1 to 25 carbon atoms which may have a substituent, an crotonate including a bicycle ring and having from 1 to 25 carbon atoms which may have a substituent, an aralkyl crotonate having from 1 to 25 carbon atoms which may have a substituent, an aryl crotonate having from 1 to 25 carbon atoms which may have a substituent,
a benzoyloxyethylene having from 1 to 25 carbon atoms which may have a substituents, an acetoxyethylene having from 1 to 25 carbon atoms which may have a substituent, (meth)acrylonitrile, (meth)crotonitrile, vinyl carbazole having from 1 to 25 carbon atoms which may have a substituent and a vinyl pyrrolidone are preferable,
(meth)acrylic acid, an alkyl or cycloalkyl (meth)acrylate having from 1 to 20 carbon atoms which may have a substituent, a (meth)acrylate including a bicycle ring and having from 1 to 20 carbon atoms which may have a substituent, an aralkyl (meth)acrylate having from 1 to 20 carbon atoms which may have a substituent, an aryl (meth)acrylate having from 1 to 20 carbon atoms which may have a substituent,
(meth)acrylamide, a secondary or tertiary, alkyl or cycloalkyl(meth)acrylamide having from 1 to 20 carbon atoms which may have a substituent, a secondary or tertiary (meth)acrylamide including a bicycle ring and having from 1 to 20 carbon atoms which may have a substituent, a secondary or tertiary aralkyl (meth)acrylamide having from 1 to 20 carbon atoms which may have a substituent, a secondary or tertiary aryl (meth)acrylamide having from 1 to 20 carbon atoms which may have a substituent, (meth)acryloyl morpholine having from 1 to 20 carbon atoms which may have a substituent,
a substituted or unsubstituted aromatic hydrocarbon ring including a vinyl group and having from 1 to 20 carbon atoms, a substituted or unsubstituted heteroaromatic ring including a vinyl group and having from 1 to 20 carbon atoms, maleic anhydride, a substituted or unsubstituted partially esterified maleic acid having from 1 to 20 carbon atoms, a substituted or unsubstituted partially amidated maleic acid having from 1 to 20 carbon atoms, a substituted or unsubstituted (α-methyl)styrene having from 1 to 20 carbon atoms, methyl jasmonate,
itaconic acid, an alkyl or cycloalkyl itaconate having from 1 to 20 carbon atoms which may have a substituent, an itaconate including a bicycle ring and having from 1 to 20 carbon atoms which may have a substituent, an aralkyl itaconate having from 1 to 20 carbon atoms which may have a substituent, an aryl itaconate having from 1 to 20 carbon atoms which may have a substituent,
crotonic acid, an alkyl or cycloalkyl crotonate having from 1 to 20 carbon atoms which may have a substituent, an crotonate including a bicycle ring and having from 1 to 20 carbon atoms which may have a substituent, an aralkyl crotonate having from 1 to 20 carbon atoms which may have a substituent, an aryl crotonate having from 1 to 20 carbon atoms which may have a substituent,
a benzoyloxyethylene having from 1 to 20 carbon atoms which may have a substituent, an acetoxyethylene having from 1 to 20 carbon atoms which may have a substituent, a vinyl carbazole having from 1 to 20 carbon atoms which may have a substituent, vinyl pyrrolidone (meth)acrylonitrile and (meth)crotonitrile are more preferable,
(meth)acrylic acid; methyl (meth)acrylate, ethyl(meth)acrylate, straight-chain or branched propyl (meth)acrylate, straight-chain or branched butyl (meth)acrylate, straight-chain or branched pentyl (meth)acrylate, n-hexyl (meth)acrylate, cyclohexyl (meth)acrylate, n-heptyl (meth)acrylate. 2-ethylhexyl (meth)acrylate, n-octyl (meth)acrylate, n-decyl (meth)acrylate and n-dodecyl (meth)acrylate each of which may have a substituent;
adamantyl (meth)acrylate, isobomyl (meth)acrylate, norbomanemethyl (meth)acrylate and norbornenemethyl (meth)acrylate each of which may have a substituent; benzyl (meth)acrylate, naphthylmethyl (meth)acrylate, anthracenemethyl (meth)acrylate and phenylethyl (meth)acrylate each of which may have a substituent; phenyl (meth)acrylate and naphthyl (meth)acrylate each of which may have a substituent;
(meth)acrylamide; methyl or dimethyl(meth)acrylamide, ethyl or diethyl(meth)acrylamide, mono- or di-(straight-chain or branched propyl)(meth)acrylamide, mono- or di-(straight-chain or branched butyl)(meth)acrylamide, mono- or di-(straight-chain or branched pentyl)(meth)acrylamide, n-hexyl or di-n-hexyl(meth)acrylamide, cyclohexyl or dicyclohexyl(meth)acrylamide and 2-ethylhexyl or di-2-ethylhexyl(meth)acrylamide each of which may have a substituent; adamantyl(meth)acrylamide and noradarnantyl(meth)acrylamide each of which may have a substituent; benzyl(meth)acrylamide, naphthylethyl(meth)acrylamide and phenylethyl(meth)acrylamide each of which may have a substituent; phenyl or diphenyl(meth)acrylamide, naphthyl(meth)acrylamide, (meth)acryloyl morpholine, piperidyl acrylamide and pyrrolidyl acrylamide each of which may have a substituent;
(α-methyl)styrene; vinyl pyridine; vinyl imidazole; vinyl triazole; maleic anhydride; methyl jasmonate; (N-substituted) maleimide; itaconic acid; crotonic acid; methyl crotonate, ethyl crotonate, straight-chain or branched propyl crotonate, straight-chain or branched butyl crotonate, straight-chain or branched pentyl crotonate, n-hexyl crotonate, cyclohexyl crotonate, n-heptyl crotonate, 2-ethylhexyl crotonate, n-octyl crotonate, n-decyl crotonate and n-dodecyl crotonate each of which may have a substituent; adamantyl crotonate, isobomyl crotonate, norbornanemethyl crotonate and norbomenemethyl crotonate each of which may have a substituent; benzyl crotonate, naphthylmethyl crotonate, anthracenemethyl crotonate and phenylethyl crotonate each of which may have a substituent; phenyl crotonate and naphthyl crotonate each of which may have a substituent;
benzoyloxyethylene which may have a substituent; acetoxyethylene which may have a substituent; vinyl carbazole which may have a substituent and vinyl pyrrolidone; acrylonitrile; and methacrylonitrile are particularly preferable.

The carboxy group described above may be a form of a metal salt.

As the substituent, an alkyl group having from 1 to 20 carbon atoms, an alkoxy group having from 1 to 20 carbon atoms, an aralkyl group having from 1 to 20 carbon atoms, an aryl group having from 1 to 20 carbon atoms, an acyloxy group having from 1 to 20 carbon atoms, an acyl group having from 1 to 20 carbon atoms, an alkoxycarbonyl group having from 1 to 20 carbon atoms, an arylcarbonyl group having from 1 to 20 carbon atoms, a dialkylamino group having from 1 to 20 carbon atoms, a monoaklylamino group having from 1 to 20 carbon atoms, a halogen atom, a cyano group, a furyl group, a furfuryl group, a tetrahydrofuryl group, a tetrahydrofurfuryl group, an alkylthio group, a trimethylsilyl group, a trifluoromethyl group, a carboxyl group, a thienyl group, a morpholino group, a morpholinocarbonyl group, a vinyl group, -SO₃M group (M represents a hydrogen atom, Na or K), -COOM group (M represents a hydrogen atom, Na or K), a (meth)acryloyloxy group and a phenyl group are preferable,
an alkyl group having from 1 to 15 carbon atoms, an alkoxy group having from 1 to 15 carbon atoms, an aralkyl group having from 1 to 15 carbon atoms, an aryl group having from 1 to 20 carbon atoms, an acyloxy group having from 1 to 15 carbon atoms, an acyl group having from 1 to 15 carbon atoms, an alkoxycarbonyl group having from 1 to 15 carbon atoms, an arylcarbonyl group having from 1 to 15 carbon atoms, a dialkylamino group having from 1 to 15 carbon atoms, a monoaklylamino group having from 1 to 15 carbon atoms, a halogen atom, a cyano group, a furyl group, a furfuryl group, a tetrahydrofuryl group, a
tetrahydrofurfuryl group, an alkylthio group, a trimethylsilyl group, a trifluoromethyl group, a carboxyl group, a thienyl group, a morpholino group, a morpholinocarbonyl group, a vinyl group, -SO₃M group (M represents a hydrogen atom, Na or K), -COOM group (M represents a hydrogen atom, Na or K), a (meth)acryloyloxy group and a phenyl group are more preferable,
a methyl group, an ethyl group, a straight-chain or branched propyl group, a straight-chain or branched butyl group, a straight-chain or branched pentyl group, a n-hexyl group, a cyclohexyl goup, a n-heptyl group, a 2-ethylhexyl group, a n-octyl group, a n-decyl group, a n-dodecyl group, a methyloxy group, an ethyloxy group, a srtraight-chain or branched propyloxy group, a straight-chain or branched butyloxy group, a straight-chain or branched pentyloxy group, a n-hexyloxy group, a cyclohexyloxy group, a n-heptyloxy group, a 2-ethylhexyloxy group, a n-octyloxy group, a n-decyloxy group, a n-dodecyloxy group, a benzyl group, a phenethyl group, a naphthylmethyl group, a naphthylethyl group, a phenyl group, a naphthyl group,
a methylcarbonyloxy group, an ethylcarbonyloxy group, a straight-chain or branched propylcarbonyloxy group, a straight-chain or branched butylcarbonyloxy group, a straight-chain or branched pentylcarbonyloxy group, a n-hexylcarbonyloxy group, a cyclohexylcarbonyloxy group, a n-heptylcarbonyloxy group, a 2-ethylhexylcarbonyloxy group, a n-octylcarbonyloxy group, a n-decylcarbonyloxy group, a n-dodecylcarbonyloxy goup,
a methylcarbonyl group (acetyl group), an ethylcarbonyl group, a straight-chain or branched propylcarbonyl group, a straight-chain or branched butylcarbonyl group, a straight-chain or branched pentylcarbonyl group, a n-hexylcarbonyl group, a cyclohexylcarbonyl group, a n-heptylearbonyl group, a 2-ethylhexylcarbonyl group, a n-octylcarbonyl group, a n-decylcarbonyt group, a n-dodecylcarbonyl group,
a methyloxycarbonyl group, an ethyloxycarbonyl group, a straight-chain or branched propyloxycarbonyl group, a straight-chain or branched butyloxycarbonyl group, a stmight-chain or branched pentyloxycarbonyl group, a n-hexyloxycarbonyl group, a cyclohexyloxycarbonyl group, a n-heptyloxycarbonyl group, a 2-ethylhexyloxycarbonyl group, a n-octyloxycarbonyl group, a n-decyloxycarbonyl group, a n-dodecyloxycarbonyl groups, a benzoyl group, a naphthylcarbonyl group,
a methyl or dimetylamino group, a ethyl or diethylamino group, a mono- or di-(straight-chain or branched propyl)amino group, a mono- or di-(straight-chain or branched butyl)amino group, a mono- or di-(straight-chain or branched pentyl)amino group, a n-henyl or di-(n-hexyl)amino group, a cyclohenyl or di-cyclohexylamino group, a n-heptyl or di-(n-heptyl)amino group, a 2-ethylhexyl or di-(2-ethylhexyl)amino group,
a fluorine atom, a chlorine atom, a bromine atom, a cyano group, a furyl group, a furfuryl group, a tetrahydrofuryl group, a tetrahydrofurfuryl group, an alkylthio group, a trimethylsilyl group, a trifluoromethyl group, a carboxyl group, a thienyl group, a morpholino group, a morpholinocarbonyl group, a vinyl group, -SO₃M group (M represents a hydrogen atom, Na or K), -COOM group (M represents a hydrogen atom, Na or K), a (meth)acryloyloxy group and a phenyl group are particularly preferable.

These substituents may be further substituted with the substituents described above. In addition, as a monomer having hydrophilicity, a monomer including phosphoric acid, a phosphoric acid ester, a quaternary ammonium salt, an ethyleneoxy chain, a propyleneoxy chain, a sulfonic acid or its salt or a morpholinoethyl group is also useful.

The sulfo group or carboxyl group may be a form of a divalent or more valent metal salt.

The kind of monomers to be copolymerize is not particularly restricted and 1 to 12 kinds of monomers is preferable, 1 to 8 kinds of monomers is more preferable, and 1 to 5 kinds of monomers is particularly preferable.

The average particle size of the latex used in the invention is preferably 5 µm or less, more preferably 4 µm or less, and particularly preferably 3 µm or less, from the standpoint of the dispersion stability.

The protective colloid used for dispersion stabilization of the latex used in the invention is not particularly restricted as long as it has an ability as the protective colloid. Examples of the protective colloid include an anionic surfactant, a cationic surfactant, an amphoteric surfactant a nonionic surfactant and a polymer having both a hydrophobic part and a hydrophilic part. Protective colloids described, for example, in Kagaku Binran, Jikken Kagaku Koza (edited by Japanese Chemical Society) and Takayuki Otsu, Kobunshigosei no Jikkenho, Kagaku-Dojin Publishing Co. Inc. can be utilized.

Specifically, various polyvinyl alcohols, sodium dodecylbenzenesulfonate, sodium dodecylsulfonate, C₁₆H₃₃N⁺(CH₃)Br⁻, C₁₂H₂₅N⁺(CH₃)₂COO⁻, C₁₂H₂₅(OC₂H₄)₂OH, n-octyl-β-D-glucoside, C₆F₁₃CH₂(OC₂H₄)₁₄OH, C₈F₁₇CH₂CH₂N(C₂H₄OH)₂, C₁₅H₃₁CON(C₂H₄OH)₂, (CH₃)SiO[Si(CH₃)₂O]₃-Si and (CH₃)₂CH₂(C₂H₄O)_{8.2}CH₃ are exemplified.

Among them, an anionic surfactant, an amphoteric surfactant, a nonionic surfactant and various polyvinyl alcohols are preferable, an anionic surfactant, an amphoteric surfactant and various polyvinyl alcohols are more preferable, and an anionic surfactant and an amphoteric surfactant are particularly preferable.

The emulsion polymerization may be conducted under any of increased pressure, normal pressure or reduced pressure, and it is preferable to conduct under normal pressure in view of the simplicity of the production.

The polymerization reaction temperature of the emulsion polymerization is not particularly restricted as long as it can facilitate the polymerization reaction, and it is preferably 300°C or less, more preferably 200°C or less, and particularly preferably 100°C or less, in view of the simplicity of the production.

The polymerization initiator for use in the polymerization is also not particularly restricted as long as it is a compound capable of polymerizing a carbon-carbon double bond, and polymerization initiators described, for example, in Kagaku Binran, Jikken Kagaku Koza (edited by Japanese Chemical Society) and Takayuki Otsu, Kobunshigosei no Jikkenho, Kagaku-Dojin Publishing Co. Inc. can be preferably utilized from the standpoint of the polymerizability, cost, simplicity of operation or the like.

Specifically, for example, a peroxide initiator, azo initiator and a redox initiator are exemplified. Of the initiators, benzoyl peroxide, di-tert-butyl peroxide, lauroyl peroxide, ter-butyl hydroperoxide, cumen hydroperoxide, ammonium persulfate, potassium persulfate, acetyl peroxide, tetramethyl thiuramdisulfide, azobisisobutyronitrile, azobiscyclohexanonitrile, phenylazotriphenylmethane, and VA-086, V-50, VA-044 and V-501 (water-soluble azo initiators, produced by Wako Pure Chemical Industries, Ltd.) are preferable,
benzoyl peroxide, di-tert-butyl peroxide, lauroyl peroxide, ter-butyl hydroperoxide, cumen hydroperoxide, ammonium persulfate, potassium persulfate, acetyl peroxide, azobisisobutyronitrile, azobiscyclohexanonitrile, VA-086, V-50, VA-044 and V-501 are more preferable,
benzoyl peroxide, di-tert-butyl peroxide, lauroyl peroxide, ter-butyl hydroperoxide, cumen hydroperoxide, ammonium persulfate, potassium persulfate, azobisisobutyronitrile, azobiscyclohexanonitrile, VA-086, V-50, VA-044 and V-501 are particularly preferable.

From the standpoint of the dispersion stability of latex, an initiator generating an anionic terminal group is preferable and from this point of view, a persulfate compound is preferably used.

In the emulsion polymerization, the amount of the total monomer in the whole polymerization reaction mixture is preferably 50% by weight or less, more preferably 20% by weight or less, particularly preferably 15% by weight or less, in view of the dispersion stability.

In the emulsion polymerization, the amount of the polymerization initiator is preferably 30% by weight or less, more preferably 20% by weight or less, particularly preferably 10% by weight or less, based on the amount of the total monomer from the standpoint of the dispersion stability, cost or the like.

After the emulsion polymerization, the step of distilling off of the remaining monomer may be conducted under reduced pressure or under nitrogen gas, argon gas or air stream. It is preferred to conduct under nitrogen gas or air stream, from the standpoint of the efficiency of the distilling off of the remaining monomer and production cost, and particularly preferred to conduct under nitrogen gas in view of preventing the product from oxidation. The distilling off may be conduced with heating or at normal temperature.

With respect to the distilling off of the remaining monomer, the distilling off efficiency can be increased by adding a solvent to the latex produced and removing by heating and azeotropy as the method described in U.S. Patent 4,414,063.

In another method, to the latex produced is added an inorganic salt, for example, sodium hydrogen carbonate or sodium chloride to perform salting out/filtration, thereby removing the unreacted monomer.

### [Lithographic printing plate precursor]

The lithographic printing plate precursor according to the invention comprises a protective layer containing a polymer containing acrylonitrile as a repeating unit.

The lithographic printing plate precursor according to the invention preferably comprises an image-recording layer containing (A) a radical generator, (B) a sensitizing dye and (c) a compound having at least one addition-polymerizable ethylenically unsaturated bond. The image-recording layer preferably includes further (D) a binder polymer and (E) a microcapsule or microgel.

The image-recording layer is a so-called image-recording layer capable of undergoing on-machine development, which can be recorded by infrared exposure and is subjected to a printing procedure after the recording of image by infrared exposure without undergoing any wet development processing step to conduct printing, whereby the unexposed area thereof is removed with an oily component and/or hydrophilic component, for example, ink and dampening water, in the course of printing.

Each element of the lithographic printing plate precursor according to the invention including the protective layer and the image-recording layer will be described in greater detail below,

### (Protective layer)

The protective layer according to the invention is characterized by containing as a main component, a polymer containing as a repeating unit, acrylonitrile. The terminology "containing as a main component" as used herein means that the content is 60% by weight or more of the solid content constituting the protective layer. The content is preferably 70% by weight or more.

In order to solve the problems on the protective layer as described above, it is important to prevent interlayer mixing occurred between the image-recording layer and the protective layer, when they are laminated. Thus, it is preferred that the polymer containing acrylonitrile used in the protective layer has a higher molecular weight or is used as a polymer latex. From the standpoint of the production of lithographic printing plate precursor, water or a water-organic solvent mixing system is preferably used as a coating solvent in the formation of protective layer and thus, it is particularly preferred to use a polymer latex containing acrylonitrile.

The content of acrylonitrile in the polymer is preferably 60% by weight or more, more preferably 70% by weight or more, particularly preferably 80% by weight or more, and most preferably 90% by weight or more. When the content is less than 60% by weight, the oxygen blocking property materially decreases and good image formation is difficult.

As the polymer containing acrylonitrile for use in the protective layer of the lithographic printing plate precursor according to the invention, the polymer latex of high acrylonitrile content synthesized by the production method of the acrylonitrile-containing polymer latex described above is preferably used.

The average particle size of the polymer latex is preferably 5 µm or less, more preferably 4 µm or less, particularly preferably 3 µm or less, from the standpoint of the dispersion stability.

In the protective layer according to the invention, other polymer may be used together in a range where the function of the polymer containing acrylonitrile is not damaged. As the other polymer used together, any water-soluble polymer and water-insoluble polymer can be appropriately selected to use. Specifically, a water-soluble polymer, for example, polyvinyl alcohol, modified polyvinyl alcohol, polyvinyl pyrrolidone, polyvinyl imidazole, polyacrylic acid, polyacrylamide, partially saponified product of polyvinyl acetate, ethylene-vinyl alcohol copolymer, water-soluble cellulose derivative, gelatin, starch derivative or gum arabic, and a polymer, for example, polyvinylidene chloride, poly(meth)acrylonitrile, polysulfone, polyvinyl chloride, polyethylene, polycarbonate, polystyrene, polyamide or cellophane are exemplified. The other polymers used together may be used in combination of two or more thereof, if desired.

As a relatively useful material of the other polymers, a water-soluble polymer compound excellent in crystallinity is exemplified. Specifically, polyvinyl alcohol, polyvinyl pyrrolidone, polyvinyl imidazole, a water-soluble acrylic resin, for example, polyacrylic acid, gelatin or gum arabic is preferably used. Above all, polyvinyl alcohol, polyvinyl pyrrolidone and polyvinyl imidazole are more preferably used from the standpoint of capability of coating with water as a solvent and easiness of removal with dampening water at printing. Among them, polyvinyl alcohol (PVA) provides most preferable results on the fundamental properties, for example, oxygen blocking property or removability with development.

The polyvinyl alcohol for use in the protective layer may be partially substituted with ester, ether or acetal as long as it contains a substantial amount of unsubstituted vinyl alcohol units necessary for maintaining water solubility. Also, the polyvinyl alcohol may partially contain other copolymerization components. For instance, polyvinyl alcohols of various polymerization degrees having at random a various kind of hydrophilic modified cites, for example, an anion-modified cite modified with an anion, e.g., a carboxyl group or a sulfo group, a cation-modified cite modified with a cation, e.g., an amino group or an ammonium group, a silanol-modified cite or a thiol-modified cite, and polyvinyl alcohols of various polymerization degrees having at the terminal of the polymer having a various kind of modified cites, for example, the above-described anion-modified cite, cation modified cite, silanol-modified cite or thiol-modified cite, an alkoxy-modified cite, a sulfide-modified cite, an ester modified cite of vinyl alcohol with a various kind of organic acids, an ester modified cite of the above-described anion-modified cite with an alcohol or an epoxy-modified cite are also preferably used.

Preferable examples of the polyvinyl alcohol include those having a hydrolysis degree of 71 to 100% and a polymerization degree of 300 to 2,400. Specific examples of the polyvinyl alcohol include PVA-105, PVA-110, PVA-117, PVA-117H, PVA-120, PVA-124, PVA-124H, PVA-CS, PVA-CST, PVA-HC, PVA-203, PVA-204, PVA-205, PVA 210, PVA-217, PVA-220, PVA-224, PVA-217EE, PVA-217E, PVA-220E, PVA-224E, PVA-405, PVA-420, PVA-613 and L-8 all produced by Kuraray Co., Ltd. Specific examples of the modified polyvinyl alcohol include that having an anion-modified cite, for example, KL-318, KL-118, KM-618, KM-118 or SK-5102, that having a cation-modified cite, for example, C-318, C-118 or CM-318, that having a terminal thiol-modified cite, for example, M-205 or M-115, that having a terminal sulfide-modified cite, for example, MP-103, MP-203, MP-102 or MP-202, that having an ester-modified cite with a higher fatty acid at the terminal, for example, HL-12E or HL-1203 and that having a reactive silane-modified cite, for example, R-1130, R-2105 or R-2130.

The protective layer may contain an inorganic stratiform compound, for example, mica. The amount of the inorganic stratiform compound contained in the protective layer is ordinarily from 5/1 to 1/100 in terms of a weight ratio of the inorganic stratiform compound to an amount of the binder used in the protective layer. When a plural kind of the inorganic stratiform compounds is used together, it is preferred that the total amount of the inorganic stratiform compounds is in the range of weight ratio described above.

The stratiform compound is incorporated into the protective layer as its dispersion.

An example of common dispersing method for the stratiform compound is described below. Specifically, from 5 to 10 parts by weight of a swellable stratiform compound that is exemplified as a preferable stratiform compound is added to 100 parts by weight of water to adapt the compound to water and to be swollen, followed by dispersing using a dispersing machine. The dispersing machine used include, for example, a variety of mills conducting dispersion by directly applying mechanical power, a high-speed agitation type dispersing machine providing a large shear force and a dispersion machine providing ultrasonic energy of high intensity. Specific examples thereof include a ball mill, a sand grinder mill, a visco mill, a colloid mill, a homogenizer, a dissolver, a polytron, a homomixer, a homoblender, a keddy mill, a jet agitor, a capillary type emulsifying device, a liquid siren, an electromagnetic strain type ultrasonic generator and an emulsifying device having Polman whistle. A dispersion containing from 5 to 10% by weight of the stratiform compound thus prepared is highly viscous or gelled and exhibits extremely good preservation stability. In the formation of a coating solution for protective layer using the dispersion, it is preferred that the dispersion is diluted with water, sufficiently stirred and then mixed with a binder solution.

An additive can be added to the protective layer for the purpose, for example, of imparting flexibility, of increasing surface quality of the layer or of improving adhesion property to the image-recording layer. As the additive, the compound, for example, plasticizer, surfactant or polymer used for the similar purpose described with respect to the film produced from the polymer latex can be used.

Further, other functions can also be provided to the protective layer. For instance, by adding a coloring agent (for example, a water-soluble dye), which is excellent in permeability for infrared ray used for the exposure and capable of efficiently absorbing light at other wavelengths, a safe light adaptability can be improved without causing decrease in the sensitivity. Moreover, a known additive may be added to a coating solution for protective layer in order to improve the preservation stability of the coating solution.

The coating solution for protective layer prepared dissolving or dispersing the necessary components in a coating solvent is coated on the image-recording layer provided on the support and then dried to form a protective layer, The coating solvent may be appropriately selected in view of the binder used, and when a water-soluble polymer is used, distilled water or purified water is preferably used as the solvent. A coating method of the protective layer is not particularly limited, and known methods, for example, methods described in U.S. Patent 3,458,311 and JP-B-55-49729 can be utilized. Specific examples of the coating method for the protective layer include a blade coating method, an air knife coating method, a gravure coating method, a roll coating method, a spray coating method, a dip coating method and a bar coating method.

The coating amount of the protective layer is preferably in a range from 0.01 to 10 g/m², more preferably in a range from 0.02 to 3 g/m², most preferably in a range from 0.02 to 1 g/m², in terms of the coating amount after drying.

### (Image-recording layer)

### <(A) Radical generator>

As the radical generator according to the invention, the compound represented by formula (I) shown below is preferably used.

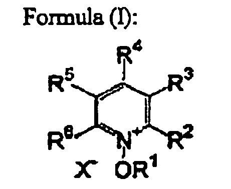

In formula (I), R¹, R², R³, R⁴, R⁵ and R⁶ each independently represents a hydrogen atom a halogen atom or a monovalent substituent, and X represents an anion.

In formula (1), the monovalent substituent includes, for example, a halogen atom, an amino group, a substituted amino group, a substituted carbonyl group, a hydroxy group, a substituted oxy group, a thiol group, a thioether group, a silyl group, a nitro group, a cyano group, an alkyl group, an alkenyl group, an aryl group, a heterocyclic group, a sulfo group, a substituted sulfonyl group, a sulfonato group, a substituted sulfinyl group, a phosphono group, a substituted phosphono group, a phosphonato group and a substituted phosphonato group, and when it is possible to introduce a substituent, the substituent may further be introduced.

The compound represented by formula (I) also includes a compound (multimer type) which contains in its molecule two or more of the skeletons (cation portions) of the specific structure in the compound represented by formula (I) connected through R¹, and such a compound is also preferably used.

Moreover, the compound represented by formula (I) may be a compound (polymer type) in which the skeletons of the specific structure are introduced into a polymer side chain through any one of R¹ to R⁶, and such an embodiment is also preferable.

Specific examples [Compounds A-1 to A-37] of the compound represented by formula (I) are set forth below, but the invention should not be construed as being limited thereto.

| | | logP |
|---|---|---|
| A-1 | 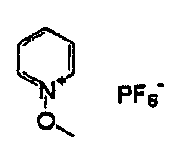 | 0.916 |
| A-2 | 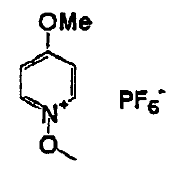 | 0.835 |
| A-3 | 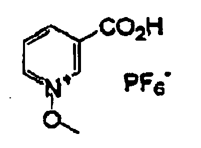 | 0.659 |
| A-4 | 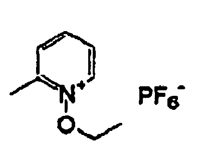 | 1.415 |
| A-5 | 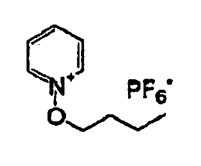 | 2. 503 |
| A-6 | 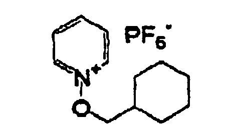 | 3.566 |
| A-7 | 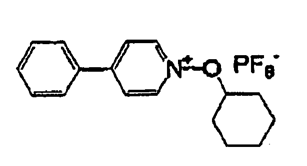 | 5.545 |
| A-8 | 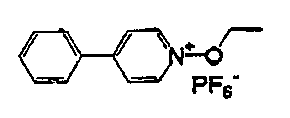 | 3.333 |
| A-9 | 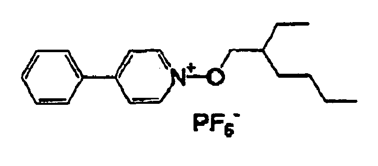 | 6.377 |
| A- 10 | 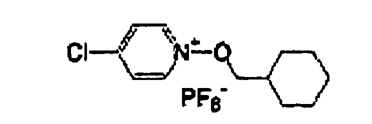 | 4.279 |
| A- 11 | 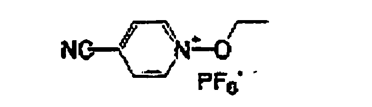 | 0.878 |
| A- 12 | 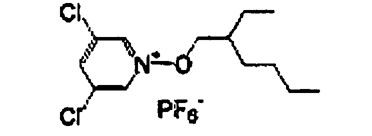 | 5.915 |
| A- 13 | 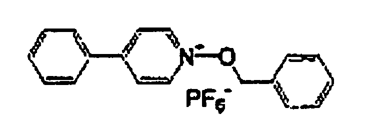 | 4.752 |
| A- 14 | 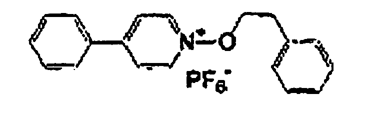 | 4.901 |
| A- 15 | 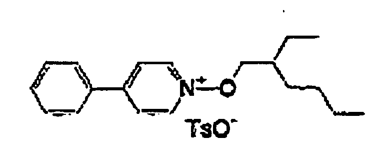 | 6.377 |
| A- 16 | 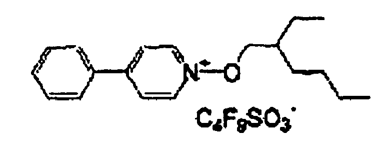 | 6.377 |
| A- 17 | 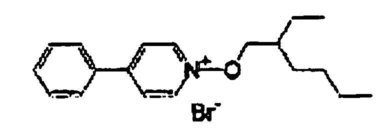 | 6.377 |
| A- 18 | 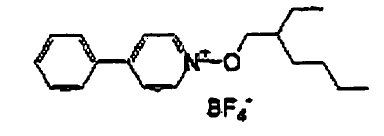 | 6.377 |
| A- 19 | 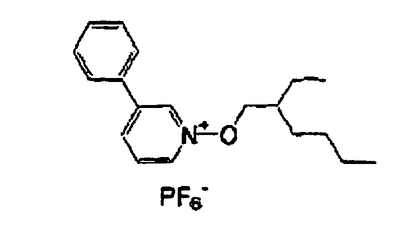 | 6.377 |
| A- 20 | 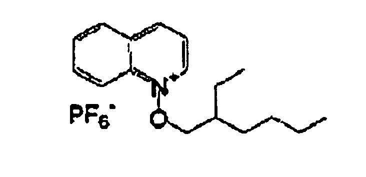 | 6.223 |
| A- 21 | 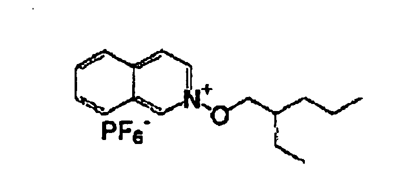 | 5.663 |
| A- 22 | 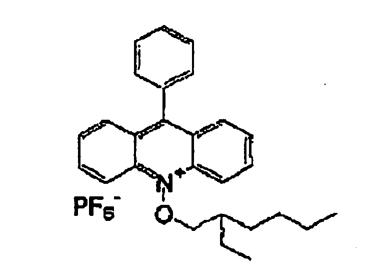 | 9.441 |
| A- 23 | 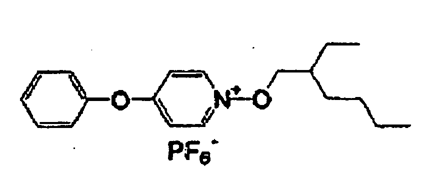 | 6.587 |
| A- 24 | 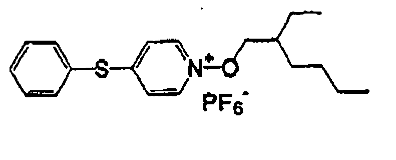 | 6.827 |
| A- 25 | 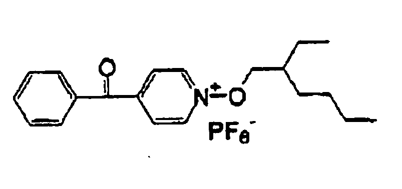 | 5.527 |
| A- 26 | 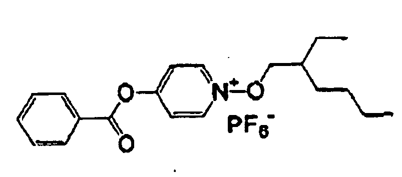 | 5.867 |
| A- 27 | 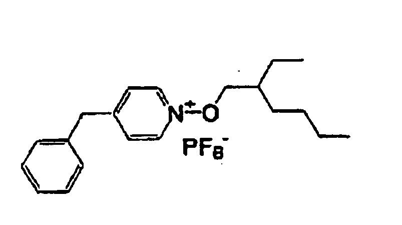 | 6.556 |
| A- 28 | 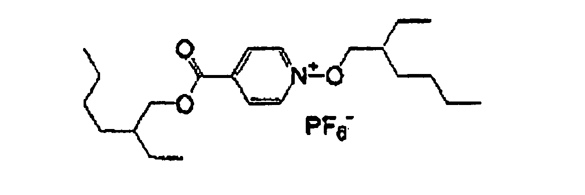 | 8. 031 |
| A- 29 | 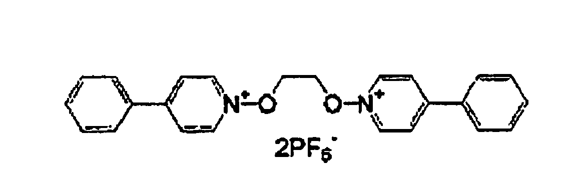 | 5.821 |
| A- 30 | 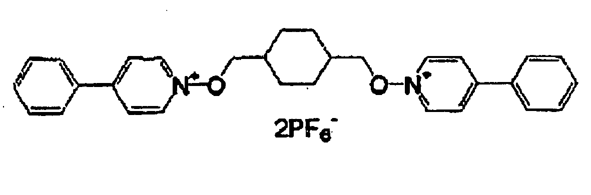 | 6.935 |
| A- 31 | 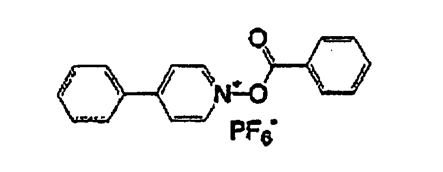 | 4.668 |
| A- 32 | 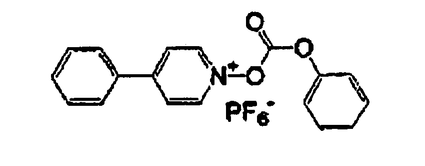 | 4.239 |

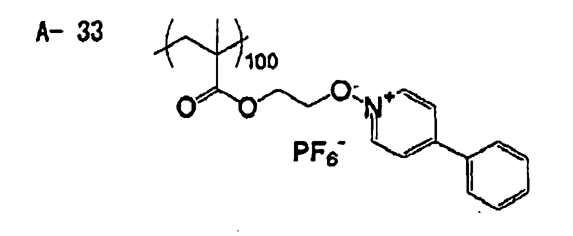

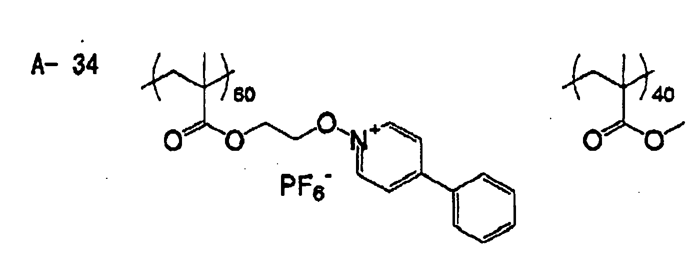

The compounds represented by formula (I) may be used individually or in combination of two or more thereof. When two or more thereof are used, a different kind of compounds, for example, the monomer type, the multimer type or the polymer type may be used in combination.

The content of the compound represented by formula (I) according to the invention is preferably from 0.1 to 50% by weight, more preferably from 0.5 to 30% by weight, still more preferably from 5 to 20% by weight, based on the total solid content of the image-recording layer of the lithographic printing plate precursor.

In the above-described range of the content, good sensitivity and good stain resistance in the non-image area at the printing are achieved. The compound represented by formula (I) may be added together with other components to one layer or may be added to a different layer separately provided.

Although the compound represented by formula (I) is particularly preferable as the radical generator (A) according to the invention, other radical initiator can be used together.

The radical generator capable of being used together with the compound represented by formula (I) in the invention can be appropriately selected from known photopolymerization initiators and compounds containing a bond having small bond dissociation energy, Specific examples thereof include the radical generators described with respect to the pattern forming material.

Of the other radical generators capable of being used together, an onium salt including as a counter ion, an inorganic anion, for example, PF₆⁻, BF₄⁻ or C₄F₉SO₃⁻ is preferable from the standpoint of improvement in the image visibility after the exposure. Further, in view of being excellent in the color-forming property, an diaryl iodonium salt including two or more electron donating groups is preferable. Such a radial generator is a compound having a diaryl iodonium skeleton and has two or more, preferably three or more electron donating groups, for example, an alkyl group or an alkoxy group on the aryl group. It is preferred that the electron donating groups are introduced into the para positions and ortho positions of the aryl groups of the iodonium salt.

The other radical generators may be used individually or in combination of two or more thereof. Further, the other radical generator may be added together with other components to one layer or may be added to a different layer separately provided.

The total content of the radical generator in the image-recording layer is preferably from 0.1 to 50% by weight, more preferably from 0.5 to 30% by weight, most preferably from 1 to 20% by weight, based on the total solid content constituting the image-recording layer.

### <(B) Sensitizing dye>

In order to improve the compatibility to a light source, for example, an infrared laser, visible light or ultraviolet laser, a sensitizing dye responding to such a light source is preferably used in the image-recording layer according to the invention.

### (1) Case of responding to infrared laser

In the case of conducting the image formation using as the light source, a laser emitting an infrared ray of 760 to 1,200 nm, ordinarily, it is essential to use an infrared absorbing agent

The infrared absorbing agent has a function of converting the infrared ray absorbed to heat and a function of being excited by the infrared ray to perform electron transfer/energy transfer to a radical generator including the compounds represented by formula (I) described above. The infrared absorbing agent for use in the invention includes a dye and pigment each having an absorption maximum in a wavelength range of 760 to 1,200 nm. The infrared absorbing dye is preferable from the standpoint of the effect.

As the dye, commercially available dyes and known dyes described in literatures, for example, Senryo Binran (Dye Handbook) compiled by The Society of Synthetic Organic Chemistry, Japan (1970) can be utilized. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Preferable examples of the dye include cyanine dyes described, for example, in JP-A-58-125246, JP-A-59-84356 and JP-A-60-78787; methine dyes described, for example, in JP-A-58-173696, JP-A-58-181690 and JP-A-58-194595; naphthoquinone dyes described, for example, in JP-A-58-112793, JP-A-58-224793, JP-A-59-48187, JP-A-59-73996, JP-A-60-52940 and JP-A-60-63744; squarylium dyes described, for example, in JP-A-58-112792; and cyanine dyes described, for example, in British Patent 434,875.

Also, near infrared absorbing sensitizers described in U.S. Patent 5,156,938 are preferably used. Further, substituted arylbenzo(thio)pyrylium salts described in U.S. Patent 3,881,924, trimethinethiapyrylium salts described in JP-A-57-142645 (corresponding to U.S. Patent 4,327,169), pyrylium compounds described in JP-A-58-181051, JP-A-58-220143, JP-A-59-41363, JP-A-59-84248, JP-A-59-84249, JP-A-59-146063 and JP-A-59-146061, cyanine dyes described in JP-A-59-216146, pentamethinethiopyrylium salts described in U.S. Patent 4,283,475, and pyrylium compounds described in JP-B-5-13514 and JP-B-5-19702 are also preferably used. Other preferred examples of the dye include near infrared absorbing dyes represented by formulae (I) and (II) described in U.S. Patent 4,756,993.

Other preferabe examples of the infrared absorbing dye according to the invention include specific indolenine cyanine dyes described in JP-A-2002-278057 as illustrated below.

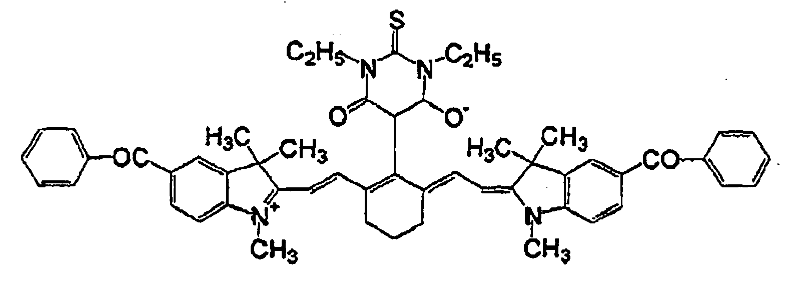

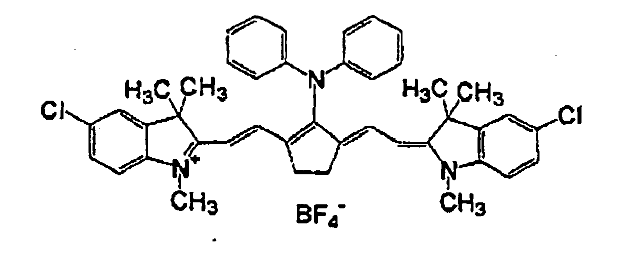

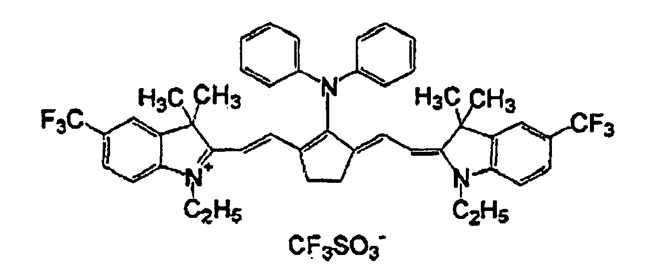

In particular, among the dyes, cyanine dyes, squarylium dyes, pyrylium dyes, nickel thiolate complexes and indolenine cyanine dyes are preferred, and from the standpoint of color change due to electron transfer, dyes containing a 5-membered ring, particularly a nitrogen-containing 5-membered hetero ring, in their molecules, are preferred. The cyanine dyes and indolenine cyanine dyes are more preferred. As a particularly preferable example of the dye, a cyanine dye represented by formula (II) shown below is exemplified.

Formula (II):

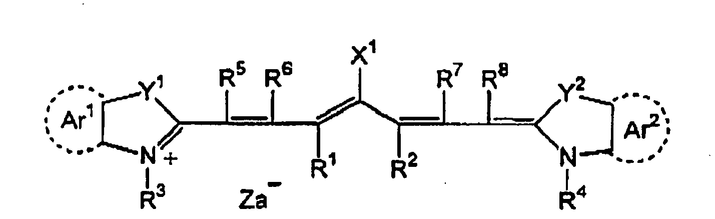

In formula (II), X¹ represents a hydrogen atom, a halogen atom, -N(aryl)₂, X²-L¹ or a group represented by a structural formula shown below. Aryl represents an aryl group which may have a substituent. X² represents an oxygen atom, a nitrogen atom or a sulfur atom, and L¹ represents a hydrocarbon group having from 1 to 12 carbon atoms, an aromatic cyclic group containing a hetero atom or a hydrocarbon group having from 1 to 12 carbon atoms and containing a hetero atom. The hetero atom means a nitrogen atom, a sulfur atom, an oxygen atom, a halogen atom or a selenium atom.

In the structural formula shown below, Xa⁻ has the same meaning as Za⁻ defined hereinafter, and R^{a} represents a hydrogen atom or a substituent selected from an alkyl group, an aryl group, a substituted or unsubstituted amino group and a halogen atom.

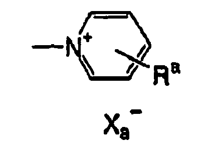

R¹ and R² each independently represents a hydrocarbon group having from I to 12 carbon atoms. In view of the preservation stability of a coating solution for image-recording layer, it is preferred that R¹ and R² each represents a hydrocarbon group having two or more carbon atoms, and particularly preferably, R¹ and R² are combined with each other to form a 5-membered or 6-membered ring.

Ar¹ and Ar², which may be the same or different, each represents an aromatic hydrocarbon group which may have a substituent. Preferable examples of the aromatic hydrocarbon group include a benzene ring and a naphthalene ring. Also, preferable examples of the substituent include a hydrocarbon group having 12 or less carbon atoms, a halogen atom and an alkoxy group having 12 or less carbon atoms, and a hydrocarbon group having 12 or less carbon atoms and an alkoxy group having 12 or less carbon atoms are most preferable. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms which may have a substituent. Preferable examples of the substituent include an alkoxy group having 12 or less carbon atoms, a carboxyl group and a sulfo group, and an alkoxy group having 12 or less carbon atoms is most preferable. R⁵, R⁶, R⁷ and R⁸, which may be the same or different, each represents a hydrogen atom or a hydrocarbon group having 12 or less carbon atoms. From the standpoint of the availability of raw materials, a hydrogen atom is preferred. Za⁻ represents a counter anion. However, Za⁻ is not necessary when the cyanine dye represented by formula (II) has an anionic substituent in the structure thereof so that neutralization of charge is not needed. Preferable examples of the counter anion for Za⁻ include a halogen ion, a perchlorate ion, a tetrafluoroborate ion, a hexafluorophosphate ion and a sulfonate ion, and particularly preferable examples thereof include a perchlorate ion, a tetrafluoroborate ion, a hexafluorophosphate ion and an arylsulfonate ion in view of the preservation stability of a coating solution for image-recording layer.

From the standpoint of improvement in the plate inspection property, Zₐ⁻ is preferably an inorganic anion or a counter anion of a strong acid. From this point of view, PF₆⁻, BF4⁻, CF₃SO₃⁻ and C₄F₉SO₃⁻ are preferable, and PF₆⁻ is most preferable.

Specific examples of the cyanine dye represented by formula (II) which can be preferably used in the invention include those described in paragraphs [0017] to [0019] of JP-A-2001-133969.

Further, other more preferable examples include the specific indolenine cyanine dyes described in JP-A-2002-278057 described above.

Examples of the pigment used in the invention include commercially available pigments and pigments described in Colour Index (C.I.), Saishin Ganryo Binran (Handbook of Newest Pigments) compiled by Pigment Technology Society of Japan (1977), Saishin Ganryo Oyou Gijutsu (Newest Application Technologies of Pigments), CMC Publishing Co., Ltd. (1986) and Insatsu Ink Gijutsu (Printing Ink Technology), CMC Publishing Co., Ltd, (1984).

Examples of the pigment include black pigments, yellow pigments, orange pigments, brown pigments, red pigments, purple pigments, blue pigments, green pigments, fluorescent pigments, metal powder pigments and polymer-bonded dyes. Specific examples of the pigment used include insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments and carbon black. Of the pigments, carbon black is preferred.

The pigment may be used without undergoing surface treatment or may be used after conducting the surface treatment. For the surface treatment, a method of coating a resin or wax on the pigment surface, a method of attaching a surfactant to the pigment surface and a method of bonding a reactive substance (for example, a silane coupling agent, an epoxy compound or a polyisocyanate) to the pigment surface. The surface treatment methods are described in Kinzoku Sekken no Seishitsu to Oyo (Properties and Applications of Metal Soap), Saiwai Shobo, Insatsu Ink Giiutsu (Printing Ink Technology). CMC Publishing Co., Ltd. (1984), and Saishin Ganryo Oyo Giiutsu (Newest Application Technologies of Pigments) CMC Publishing Co., Ltd. (1986).

A particle size of the pigment is preferably in a range from 0.01 to 10 µm, more preferably in a range from 0.05 to 1 µm, particularly preferably in a range from 0.1 to 1 µm. In the above-described range, good stability of the pigment dispersion in a coating solution for image-recording layer and good uniformity of the image-recording layer can be obtained.

As a method for dispersing the pigment, a know dispersion technique for use in the production of ink or toner can be used. Examples of the dispersing machine include an ultrasonic dispersing machine, a sand mill, an attritor, a pearl mill, a super-mill, a ball mill, an impeller, a disperser, a KD mill, a colloid mill, a dynatron, a three roll mill and a pressure kneader. The dispersing methods are described in detail in Saishin Ganryo Oyo Gijutsu (Newest Application Technologies of Pigments). CMC Publishing Co., Ltd. (1986).

Above all, the sensitizing dye (B) particularly preferable for the lithographic printing plate precursor according to the invention is a compound including at least one solvent-soluble group in the skeleton of a cyanine dye. The solvent-soluble group for use in the invention means an organic functional group capable of increasing solvent-solubility of the infrared absorbing agent and it is not particularly restricted as long as it is a functional group having such a function. It is preferably includes, for example, an alkyloxy group, an aryloxy group, an alkylcarbonyl group, an arylcarbonyl group, an alkyloxycarbonyl group, an aryloxycarbonyl group, a sulfonylamido group, a carboxyl group, a sulfo group, a hydroxy group, an alkylcarbonyloxy group, an arylcarbonyloxy group and an amido group. Among them, an alkyloxy group, an aryloxy group, an alkyloxycarbonyl group and an aryloxycarbonyl group are more preferable solvent-soluble groups, and an alkyloxy group and an aryloxy group are still more preferable solvent-soluble groups.

As the infrared absorbing agent preferable for the invention, more specifically, a compound having the cyanine dye structure represented by formula (II) described above and including at least one solvent-soluble group in its molecule is preferable. The solvent-soluble group can be introduced into any position of the cyanine dye structure represented by formula (II), and it is preferably introduced into the aromatic hydrocarbon group represented by Ar¹ or Ar², the nitrogen atoms at the both terminals, or the aromatic ring in the case where X¹ represents -N(Aryl)₂. From the standpoint of improvement in the on-machine development property, it is most preferable that the solvent-soluble groups are introduced into the nitrogen atoms at the both terminals thereof Although a number of the solvent-soluble groups introduced is at least one, it is preferable that 2 to 6 solvent-soluble groups are introduced into one molecule of the cyanine dye from the standpoint that the image-recording layer can be coated at high concentration without unevenness, that the formation of scum resulting from the components in the image-recording layer at the on-machine development is prevented, and that the on-machine development property is improved.

Specific examples of the infrared absorbing agent which can be preferably used in the invention include those set forth below, but the invention should not be construed as being limited thereto.

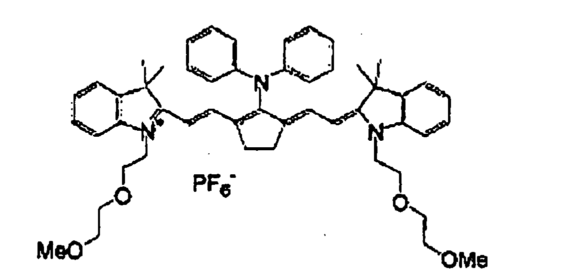

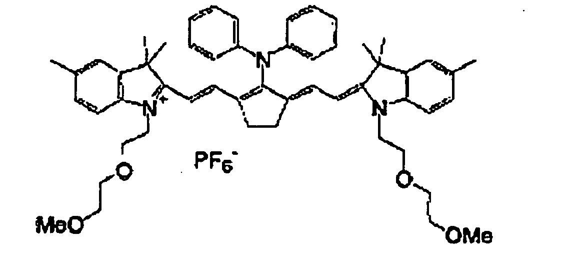

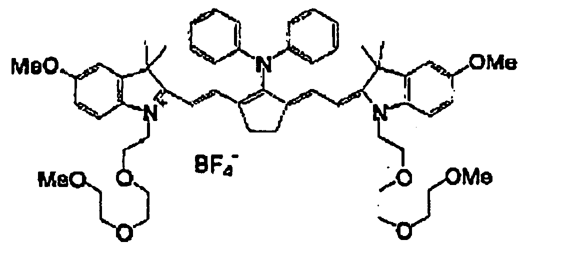

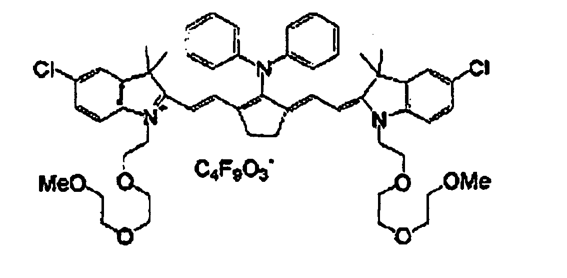

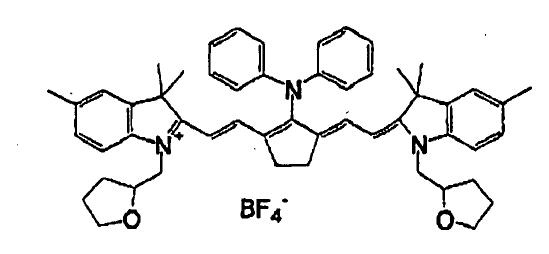

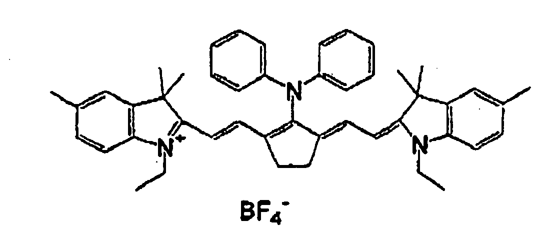

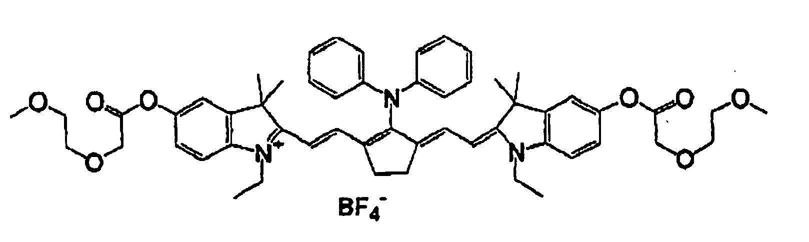

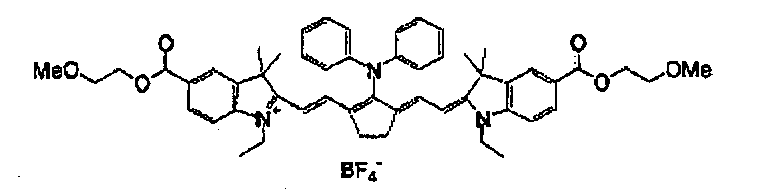

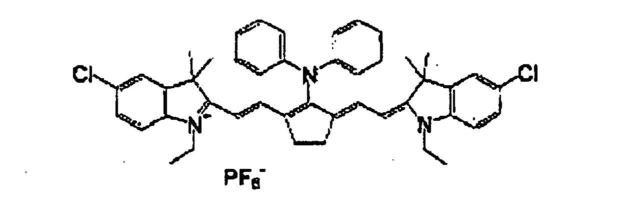

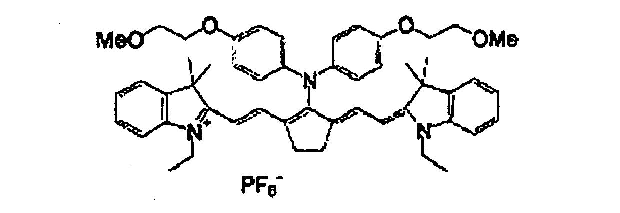

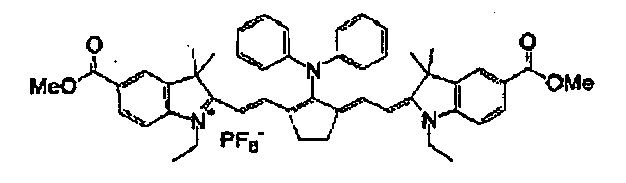

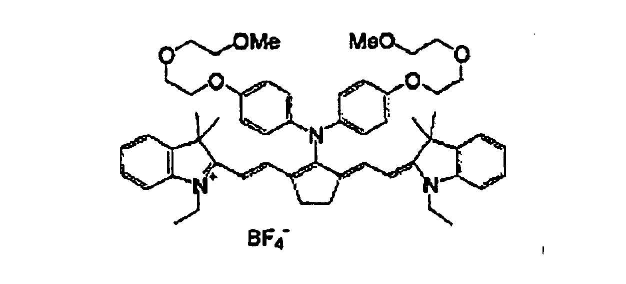

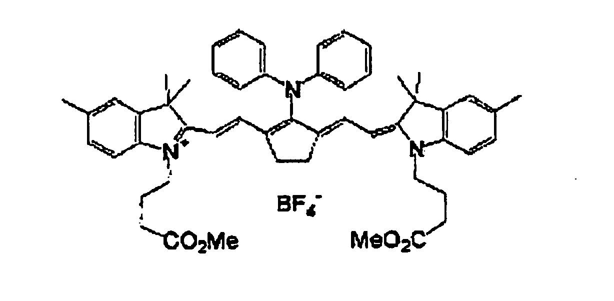

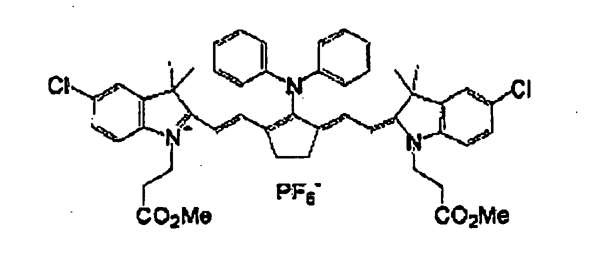

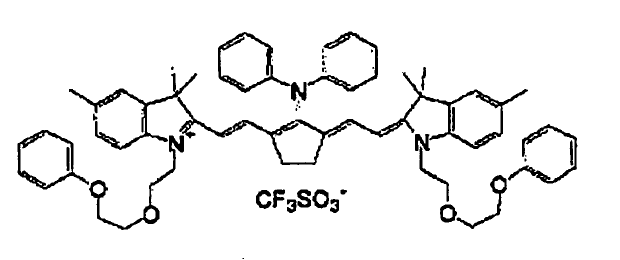

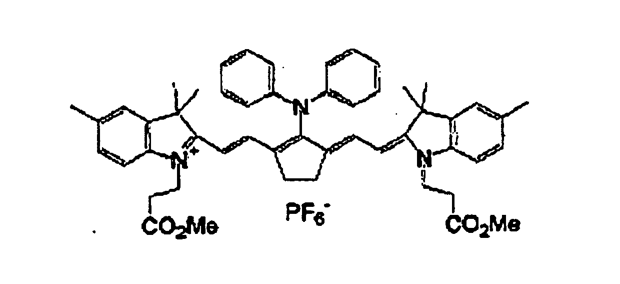

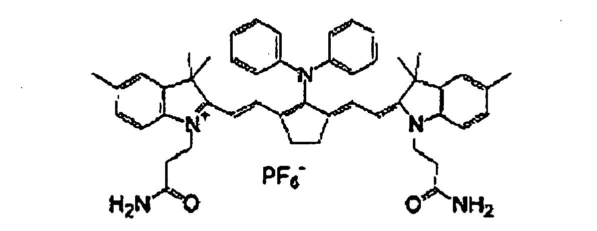

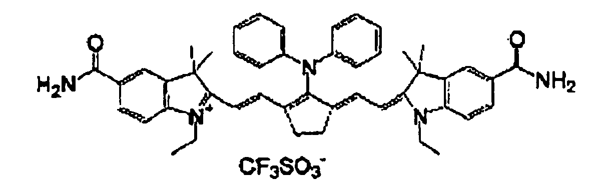

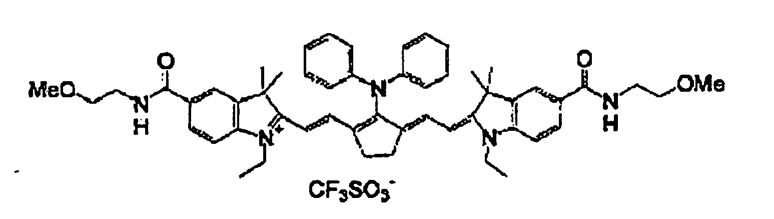

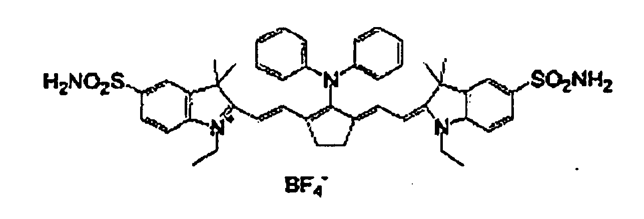

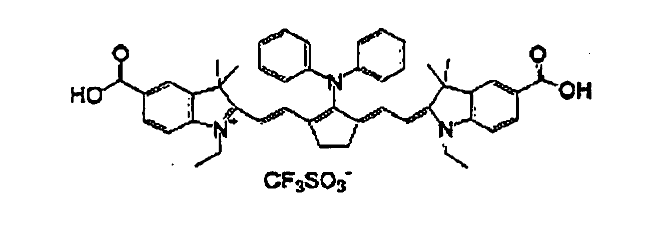

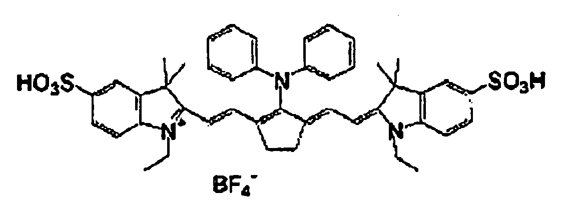

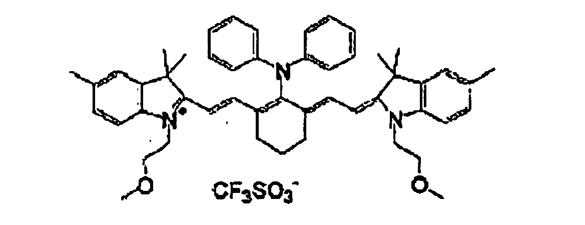

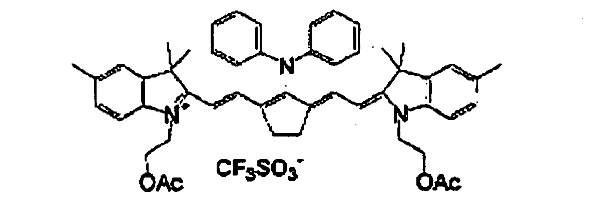

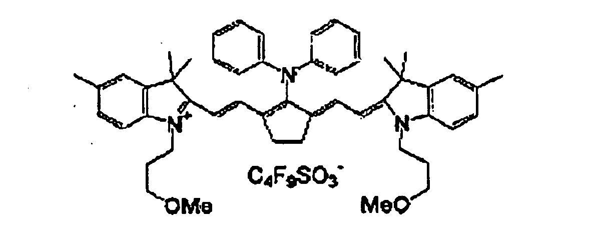

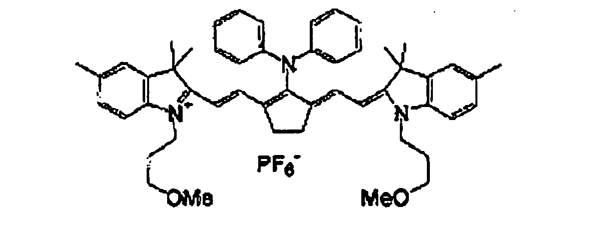

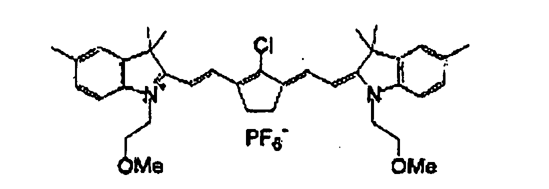

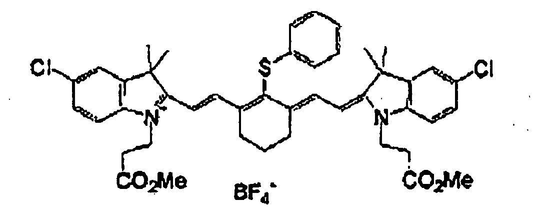

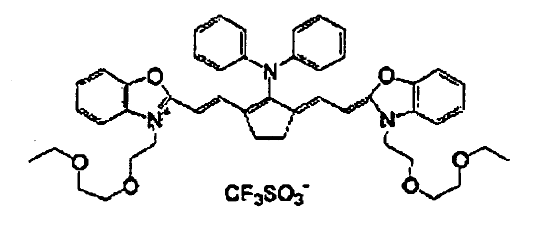

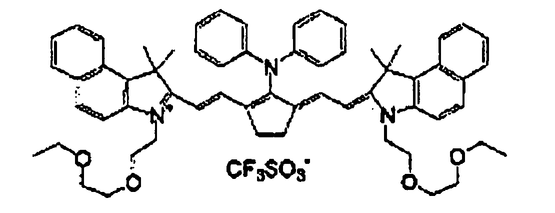

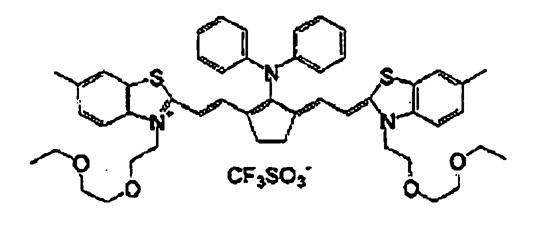

The infrared absorbing agent may be added together with other components to one layer or may be added to a different layer separately provided. With respect to an amount of the infrared absorbing agent added, in the case of preparing a negative-working lithographic printing plate precursor, the amount is so controlled that absorbance of the image-recording layer at the maximum absorption wavelength in the wavelength region of 760 to 1,200 nm measured by reflection measurement is ordinarily in a range of 0.3 to 1.2, preferably in a range of 0.4 to 1.1. In the above-described range, the polymerization reaction proceeds uniformly in the thickness direction of the image-recording layer and good film strength of the image area and good adhesion of the image area to the support are achieved.

The absorbance of the image-recording layer can be controlled depending on the amount of the infrared absorbing agent added to the image-recording layer and the thickness of the image-recording layer. The measurement of the absorbance can be carried out in a conventional manner. The method for measurement includes, for example, a method of forming an image-recording layer having a thickness appropriately determined in the range of coating amount after drying required for the lithographic printing plate precursor on a reflective support, for example, an aluminum plate, and measuring reflection density of the image-recording layer by an optical densitometer or a spectrophotometer according to a reflection method using an integrating sphere.

The amount of the infrared absorbing agent added to the image-recording layer is preferably from 0.1 to 30% by weight, more preferably from 0.5 to 20% by weight, still more preferably from 1 to 10% by weight, based on the total solid content of the image-recording layer.

### (2) Case of responding to visible light or ultraviolet laser

The image-recording layer of the lithographic printing plate precursor according to the invention contains a sensitizing dye. As the sensitizing dye, a sensitizing dye having an absorption peak in a wavelength range of 350 to 850 nm is preferable. Such a sensitizing dye includes a spectral sensitizing dye, and a dyestuff or pigment shown below which absorbs light of a light source to cause an interaction with the radical generator.

The spectral sensitizing dye or dyestuff preferably used includes, for example, a multi-nuclear aromatic compound (for example, pyrene, peryrene or triphenylene), a xanthene (for example, Fluoresceine, Eosine, Erythrocin, Rhodamine B or Rose Bengale), a cyanine (for example, thiacarbocyanine or oxacarbocyanine), a merocyanine (for example, merocyanine or carbomerocyanine), a thiazine (for example, Thionine, Methylene Blue or Toluidine Blue), an acridine (for example, Acridine Orange, chloroflavine or acriflavine), a phthalocyanine (for example, phthalocyanine or metallo-phthalocyanine), a porphyrin (for example, tetraphenyl porphyrin or center metal-substituted porphyrin), a chlorophyll (for example, chlorophyll, chlorophyllin or center metal-substituted chlorophyll), a metal complex, an anthraquirione (for example, anthraquinone) and a squalium (for example, squalium).

More preferable examples of the spectral sensitizing dye or dyestaff include styryl dyes as described in JP-B-37-13034, cationic dyes as described in JP-A-62-143044, quinoxalinium salts as described in JP-B-59-24147, new Methylene Blue compounds as described in JP-A-64-33104, anthraquinones as described in JP-A-64-56767, benzoxanthene dyes as described in JP-A-2-1714, acridines as described in JP-A-2-226148 and JP-A-2-226149, pyrylium salts as described in JP-B-40-28499, cyanines as described in JP-B-46-42363, benzofuran dyes as described in JP-A-2-63053, conjugated ketone dyes as described in JP-A-2-85858 and JP-A-2-216154, dyes as described in JP-A-57-10605, azocinnamylidene derivatives as described in JP-B-2-30321, cyanine dyes as described in JP-A-1-287105, xanthene dyes as described in JP-A-62-31844, JP-A-62-31848 and JP-A-62-143043, aminostyryl ketones as described in JP-B-59-28325, merocycnine dyes as described in JP-B-61-9621, dyes as described in JP-A-2-179643, merocycnine dyes as described in JP-A-2-244050, merocycnine dyes as described in JP-B-59-28326, merocycnine dyes as described in JP-A-59-89803, merocycnine dyes as described in JP-A-9-129257, and benzopyran dyes as described in JP-A-8-334897.

The content of the sensitizing dye in response to the visible light or ultraviolet laser is preferably from 0.1 to 50% by weight, more preferably from 0.5 to 30% by weight, still more preferably from 1 to 20% by weight, based on the total solid content of the image-recording layer.

### <(C) Compound having at least one addition-polymerizable ethylenically unsaturated bond>

In order to carry out an efficient curing reaction, a compound having at least one addition-polymerizable ethylenically unsaturated bond (C) (hereinafter, appropriately referred to as a polymerizable compound) is preferably incorporated into the image-recording layer according to the invention.

The polymerizable compound is an addition-polymerizable compound having at least one ethylenically unsaturated double bond and it is a compound having at least one, preferably two or more, terminal ethylenically unsaturated double bonds. As such a compound, the addition polymerizable compound described with respect to the pattern forming material can be used.

Details of the method of using the addition-polymerizable compound, for example, selection of the structure, individual or combination use, or the amount added, can be appropriately arranged depending on the characteristic design of the final lithographic printing plate precursor. For instance, the compound is selected from the following standpoints.

In view of the sensitivity, a structure having a large content of unsaturated groups per molecule is preferred similar to the case of the pattern forming material. Also, by using compounds different in the functional number or in the kind of polymerizable unsaturated group (for example, an acrylic acid ester, a methacrylic acid ester, a styrene compound or a vinyl ether compound) in combination, both the sensitivity and the strength can be controlled.

The selection and use method of the addition-polymerizable compound are also important factors for the compatibility and dispersibility with other components (for example, a binder polymer, a radical generator or a coloring agent) in the image-recording layer. For instance, the compatibility may be improved in some cases by using the compound of low purity or using two or more kinds of the compounds in combination. A specific structure may be selected for the purpose of improving an adhesion property to a support or a protective layer described above.

The polymerizable compound (C) is preferably used in an amount from 5 to 80% by weight, more preferably from 25 to 75% by weight, based on the nonvolatile component of the image-recording layer. The polymerizable compounds may be used individually or in combination of two or more thereof. In the method of using the polymerizable compound, the structure, blend and amount added can be appropriately selected by taking account of the extent of polymerization inhibition due to oxygen, resolution, fogging property, change in refractive index, surface adhesion and the like. Further, depending on the case, a layer construction, for example, an undercoat layer or an overcoat layer, and a coating method, may also be considered.

### <(D) Binder polymer>

In the image-recording layer according to the invention, a binder polymer can further be used, if desired, for the purpose, for example, of improving a film property of the image-recording layer to be formed.

A binder polymer which can be used in the invention can be selected from those heretofore known without restriction, and linear organic polymers having a film forming property are preferable. Examples of the binder polymer include acrylic resins, polyvinyl acetal resins, polyurethane resins, polyurea resins, polyimide resins, polyamide resins, epoxy resins, methacrylic resins, polystyrene resins, novolac type phenolic resins, polyester resins, synthesis rubbers and natural rubbers.

The binder polymer preferably has a crosslinkable property in order to improve the film strength of the image area. In order to impart the crosslinkable property to the binder polymer, a crosslinkable functional group, for example, an ethylenically unsaturated bond is introduced into a main chain or side chain of the polymer. The crosslinkable functional group may be introduced by copolymerization.

Examples of the polymer having an ethylenically unsaturated bond in the main chain thereof include poly-1,4-butadiene and poly-1,4-isoprene.

Examples of the polymer having an ethylenically unsaturated bond in the side chain thereof include a polymer of an ester or amide of acrylic acid or methacrylic acid, which is a polymer wherein the ester or amide residue (R in -COOR or -CONHR) has an ethylenically unsaturated bond.

Examples of the residue (R described above) having an ethylenically unsaturated bond include -(CH₂)ₙCR¹=CR²R³, -(CH₂O)ₙCH₂CR¹=CR²R³, -(CH₂CH₂O)ₙCH₂CR¹=CR²R³, -(CH₂)ₙNH-CO-O-CH₂CR¹=CR²R³, -(CH₂)ₙ-O-CO-CR¹=CR²R³ and -(CH₂CH₂O)₂-X (wherein R¹ to R³ each represents a hydrogen atom, a halogen atom or an alkyl group having from 1 to 20 carbon atoms, an aryl group, alkoxy group or aryloxy group, or R¹ and R² or R¹ and R³ may be combined with each other to form a ring. n represents an integer of 1 to 10. X represents a dicyclopentadienyl residue).

Specific examples of the ester residue include -CH₂CH=CH₂ (described in JP-B-7-21633), -CH₂CH₂O-CH₂CH=CH₂, -CH₂C(CH₃)=CH₂, -CH₂CH-CH-C₆H₅, -CH₂CH₂OCOCH-CH-C₆H₅, -CH₂CH₂-NHCOO-CH₂CH=CH₂ and -CH₂CH₂O-X (wherein X represents a dicyclopentadienyl residue).

Specific examples of the amide residue include -CH₂CH=CH₂, -CH₂CH₂-Y (wherein Y represents a cyclohexene residue) and -CH₂CH₂-OCO-CH=CH₂.

The binder polymer having crosslinkable property is cured, for example, by adding a free radical (a polymerization initiating radical or a growing radical of a polymerizable compound during polymerization) to the crosslinkable functional group of the polymer and undergoing addition polymerization between the polymers directly or through a polymerization chain of the polymerizable compound to form crosslinkage between the polymer molecules. Alternately, it is cured by generation of a polymer radical upon extraction of an atom in the polymer (for example, a hydrogen atom on a carbon atom adjacent to the functional crosslinkable group) by a free radial and connecting the polymer radicals with each other to form cross-linkage between the polymer molecules.

The content of the crosslinkable group in the binder polymer (content of the radical polymerizable unsaturated double bond determined by iodine titration) is preferably from 0.1 to 10.0 mmol, more preferably from 1.0 to 7.0 mmol and most preferably from 2.0 to 5.5 mmol, based on 1 g of the binder polymer. In the above-described range, preferable sensitivity and good preservation stability can be obtained.

From the standpoint of improvement in the on-machine development property, it is preferred that the binder polymer has high solubility or dispersibility in ink and/or dampening water.

In order to improve the solubility or dispersibility in the ink, the binder polymer is preferably oleophilic and in order to improve the solubility or dispersibility in the dampening water, the binder polymer is preferably hydrophilic. Therefore, it is effective in the invention that an oleophilic binder polymer and a hydrophilic binder polymer are used in combination.

The hydrophilic binder polymer preferably includes, for example, a polymer having a hydrophilic group, for example, a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfo group or a phosphoric acid group.

Specific examples thereof include gum arabic, casein, gelatin, a starch derivative, carboxy methyl cellulose and a sodium salt thereof, cellulose acetate, sodium alginate, vinyl acetate-maleic acid copolymer, styrene-maleic acid copolymer, polyacrylic acid and a salt thereof, polymethacrylic acid and a salt thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, a polyethylene glycol, a hydroxypropylene polymer, a polyvinyl alcohol, a hydrolyzed polyvinyl acetate having a hydrolysis degree of 60% by mole or more, preferably 80% by mole or more, a polyvinyl formal, a polyvinyl butyral, a polyvinyl pyrrolidone, a homopolymer or copolymer of acrylamide, a homopolymer or polymer of methacrylamide, a homopolymer or copolymer of N-methylolacrylamide, a polyvinyl pyrrolidone, an alcohol-soluble nylon, a polyether of 2,2-bis-(4-hydroxyphenyl)propane and epichlorohydrin.

The weight average molecular weight of the binder polymer is preferably 5,000 or more, more preferably from 10,000 to 300,000. The number average molecular weight of the binder polymer is preferably 1,000 or more, more preferably from 2,000 to 250,000. The polydispersity (weight average molecular weight/number average molecular weight) thereof is preferably from 1.1 to 10.

The binder polymer may be any of a random polymer and a block polymer, and preferably a random polymer. The binder polymers may be used individually or as a mixture of two or more thereof.

The binder polymer can be synthesized according to a conventionally known method. A solvent used for the synthesis include, for example, tetrahydrofuran, ethylene dichloride, cyclohexanone, methyl ethyl ketone, acetone, methanol, ethanol, ethylene glycol monomethyl ether, ethylene glycol monoethyl ether, 2-methoxyethyl acetate, diethylene glycol dimethyl ether, 1-methoxy-2-propanol, 1-methoxy-2-propylacetate, N,N-dimethylformamide, N,N-dimethylacetoamide, toluene, ethyl acetate, methyl lactate, ethyl lactate, dimethylsulfoxide and water. The solvents may be used individually or as a mixture of two or more thereof.

As a radical polymerization initiator used for the synthesis of binder polymer, a known compound, for example, an azo type initiator or a peroxide initiator can be employed.

The content of the binder polymer (D) is from 0 to 90% by weight, preferably from 0 to 80% by weight, and more preferably from 0 to 70% by weight, based on the total solid content of the image-recording layer. In the above-described range, good strength of the image area and preferable image-forming property can be obtained.

It is preferred that the polymerizable compound (C) and the binder polymer (D) are used in a weight ratio of 0.5/1 to 4/1.

Into the image-recording layer of the lithographic printing plate precursor according to the invention, various compounds can further be incorporated depending on the purposes to the extent that they do not damage the effect of the invention, in addition to the above-described components (A) to (C) and the binder polymer (D) and the like used if desired.

### <Surfactant>

In the invention, it is preferred to use a surfactant in the image-recording layer in order to promote the on-machine development property at the start of printing and to improve the state of coated surface. The surfactant used includes, for example, a nonionic surfactant, an anionic surfactant, a cationic surfactant, an amphoteric surfactant and a fluorine-based surfactant. The surfactants may be used individually or in combination of two or more thereof.

The nonionic surfactant used in the invention is not particular restricted, and those hitherto known can be used. Examples of the nonionic surfactant include polyoxyethylene alkyl ethers, polyoxyethylene alkyl phenyl ethers, polyoxyethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenated castor oils, polyoxyethylene glycerol fatty acid partial esters, fatty acid diethanolamides, N,N-bis-2-hydroxyalkylamines, polyoxyethylene alkylamines, triethanolamine fatty acid esters, trialylamine oxides, polyethylene glycols, and copolymers of polyethylene glycol and polypropylene glycol.

The anionic surfactant used in the invention is not particularly restricted and those hitherto known can be used. Examples of the anionic surfactant include fatty acid salts, abietic acid salts, hydroxyalkanesulfonic acid salts, alkanesulfonic acid salts, dialkylsulfosuccinic ester salts, straight-chain alkylbenzenesulfonic acid salts, branched alkylbenzenesulfonic acid salts, alkylnaphthalenesulfonic acid salts, alkylphenoxypolyoxyethylene propylsulfonic acid salts, polyoxyethylene alkylsulfophenyl ether salts, N-methyl-N-oleyltaurine sodium salt, N-alkylsulfosuccinic monoamide disodium salts, petroleum sulfonic acid salts, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styrylphenyl ether sulfate ester salts, alkyl phosphate ester salts, polyoxyethylene alkyl ether phosphate ester salts, polyoxyethylene alkyl phenyl ether phosphate ester salts, partial saponification products of styrene/maleic anhydride copolymer, partial saponification products of olefin/maleic anhydride copolymer and naphthalene sulfonate formalin condensates.

The cationic surfactant used in the invention is not particularly restricted and those hitherto known can be used. Examples of the cationic surfactant include alkylamine salts, quaternary ammonium salts, polyoxyethylene alkyl amine salts and polyethylene polyamine derivatives.

The amphoteric surfactant used in the invention is not particularly restricted and those hitherto known can be used. Examples of the amphoteric surfactant include carboxybetaines, aminocarboxylic acids, sulfobetaines, aminosulfuric esters, and imidazolines.

In the surfactants described above, the term "polyoxyethylene" can be replaced with "polyoxyalkylene", for example, polyoxymethylene, polyoxypropylene or polyoxybutylene, and such surfactants can also be used in the invention.

Further, a preferable surfactant includes a fluorine-based surfactant containing a perfluoroalkyl group in its molecule. Examples of the fluorine-based surfactant include an anionic type, for example, perfluoroalkyl carboxylates, perfluoroalkyl sulfonates or perfluoroalkylphosphates; an amphoteric type, for example, perfluoroalkyl betaines; a cationic type, for example, perfluoroalkyl trimethyl ammonium salts; and a nonionic type, for example, perfluoroalkyl amine oxides, perfluoroalkyl ethylene oxide adducts, oligomers having a perfluoroalkyl group and a hydrophilic group, oligomers having a perfluoroalkyl group and an oleophilic group, oligomers having a perfluoroalkyl group, a hydrophilic group and an oleophilic group or urethanes having a perfluoroalkyl group and an oleophilic group. Further, fluorine-based surfactants described in JP-A-62-170950, JP-A-62-226143 and JP-A-60-168144 are also preferably exemplified.

The surfactants can be used individually or in combination of two or more thereof. The content of the surfactant is preferably from 0.001 to 10% by weight, more preferably from 0.01 to 7% by weight, based on the total solid content of the image-recording layer.

### <Coloring agent>

In the invention, various compounds other than the above components can further be incorporated, if necessary.

For example, a dye having a large absorption in the visible region can be used as a coloring agent of the image formed. Specifically, the dye includes Oil yellow #101, Oil yellow #103, Oil pink #312, Oil green BG, Oil blue BOS, Oil blue #603, Oil black BY, Oil black BS, Oil black T-505 (produced by Orient Chemical Industries, Ltd.), Victoria pure blue, Crystal violet (CI42555), Methyl violet (CI42535), Ethyl violet, Rhodamine B (CI45170B). Malachite green (CI42000), Methylene blue (CI52015) and dyes described in JP-A-62-293247. Further, a pigment, for example, a phthalocyanine pigment, an azo pigment, carbon black or titanium oxide can also preferably be used.

It is preferred to add the coloring agent since distinction between the image area and the non-image area is easily conducted after the formation of image. The amount of the coloring agent added is preferably from 0.01 to 10% by weight based on the total solid content of the image-recording layer.

### <Print-out agent>

To the image-recording layer according to the invention, a compound causing discoloration by an acid or a radical can be added in order to form a print-out image.

According to the invention, although such a print-out agent is not always necessary because the image excellent in the plate inspection property is formed in the exposed area due to the synergetic effect of the radical generator (A) and the infrared absorbing agent (B), the print-out agent can be used together for the purpose of improving the plate inspection property

As a compound used for such a purpose, for example, dyes of diphenylmethane type, triphenylmethane type, thiazine type, oxazine type, xanthene type, anthraquinone type, iminoquinone type, azo type and azomethine type are effectively used.

Specific examples thereof include dyes, for example, Brilliant green, Ethyl violet, Methyl green, Crystal violet, basic Fuchsine, Methyl violet 2B, Quinaldine red, Rose Bengal, Methanyl yellow, Thimol sulfophthalein, Xylenol blue, Methyl orange, Paramethyl red, Congo red, Benzo purpurin 4B, α-Naphthyl red, Nile blue 2B, Nile blue A, Methyl violet, Malachite green, Parafuchsine. Victoria pure blue BOH (produced by Hodogaya Chemical Co., Ltd.), Oil blue #603 (produced by Orient Chemical Industries, Ltd.), Oil pink #312 (produced by Orient Chemical Industries, Ltd.), Oil red 5B (produced by Orient Chemical Industries, Ltd.), Oil scarlet #308 (produced by Orient Chemical Industries, Ltd.), Oil red OG (produced by Orient Chemical Industries, Ltd.), Oil red RR (produced by Orient Chemical Industries, Ltd.), Oil green #502 (produced by Orient Chemical Industries, Ltd.), Spiron Red BEH special (produced by Hodogaya Chemical Co., Ltd.), m-Cresol purple, Cresol red, Rhodamine B, Rhodamine 6G, Sulfo rhodamine B, Auramine, 4-p-diethylaminophenyliminonaphthoquione, 2-carboxyanilino-4-p-diethylaminophenyliminonaphthoquinone, 2-carboxystearylamino-4-p-N,N-bis(hydroxyethyl)aminophenyliminonaphthoquinone, 1-phenyl-3-methyl-4-p-diethylaminophenylimino-5-pyrazolon or 1-β-naphtyl-4-p-diethylanhophenylimino-5-pyrazolon, and a leuco dye, for example, p, p', p"-hexamethyltriaminotriphenylmethane (leuco crystal violet) or Pergascript Blue SRB (produced by Ciba Geigy Ltd.).

In addition to those described above, a leuco dye known as a material for heat-sensitive paper or pressure-sensitive paper is also preferably used. Specific examples thereof include crystal violet lactone, malachite green lactone, benzoyl leuco methylene blue, 2-(N-phenyl-N-methylamino)-6-(N-p-tolyl-N-ethyl)aminofluoran, 2-anilino-3-methyl-6-(n-ethyl-p-tolidino)fluoran, 3,6-dimethoxyfluoran, 3-(N,N-diethylamino)-5-methyl-7-(N,N-dibenzylamino)fluoran, 3-(N-cyclohexyl-N-methylamino)-6-methyl-7-anilinofluoran, 3-(N-N-diethylamino)-6-methyl-7-anilinofluoran, 3-(N,N-diethylamino)-6-methyl-7-xylidinofluoran, 3-(N,N-diethylamino)-6-methyl-7-chlorofluoran, 3-(N,N-ethylamino)-6-methoxy-7-minofluoran, 3-(N,N-diethylanino)-7-(4-chloroanilino)fluoran, 3-(N,N-diethylamino)-7-chlorofluoran, 3-(N,N-diethylamino)-7-benzylaminofluoran, 3-(N,N-diethylamino)-7,8-benzofluoran, 3-(N,N-dibutylamino)-6-methyl-7-anilinofluoran, 3-(N,N-dibutylamino)-6-methyl-7-xylidinofluoran, 3-pipelidino-6-methyl-7-anilinofluoran, 3-pyrolidino-6-methyl-7-anilinofluoran, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-phthalide and 3-(4-diethylaminophenyl)-3-(1-ethyl-2-methylindol-3-yl)phthalide.

The dye discolored by an acid or radical is preferably added in an amount of 0.01 to 10% by weight based on the solid content of the image-recording layer.

### <Polymerization inhibitor>

It is preferred to add a small amount of a thermal polymerization inhibitor to the image-recording layer according to the invention in order to inhibit undesirable thermal polymerization of the polymerizable compound (C) during the production or preservation of the image-recording layer.

The thermal polymerization inhibitor preferably includes, for example, hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-tert-butylphenol) and N-nitroso-N-phenylhydroxylamine aluminum salt.

The amount of the thermal polymerization inhibitor added is preferably from about 0.01 to about 5% by weight based on the total solid content of the image-recording layer.

### <Higher fatty acid derivative>

To the image-recording layer according to the invention, a higher fatty acid derivative, for example, behenic acid or behenic acid amide may be added to localize on the surface of the image-recording layer during a drying step after coating in order to avoid polymerization inhibition due to oxygen. The amount of the higher fatty acid derivative added is preferably from about 0.1 to about 10% by weight based on the total solid content of the image-recording layer,

### <Plasticizer>

The image-recording layer according to the invention may also contain a plasticizer in order to improve the on-machine development property. The plasticizer preferably includes, for example, a phthalic acid ester, e.g., diemthylphthalate, diethylphthalate, dibutylphthalate, dlisobutylphthalate, dioctylphthalate, octylcaprylphthalate, dicyclohexylphthalate, ditridecylphthalate, butylbenzylphthalate, diisodecylphthalate or diallylphthalate; a glycol ester, e.g., dimethylglycolphthalate, ehtylphtalylethylglycolate, methylphthalylethylglycolate, butylphthalylbutylglycolate or triethylene glycol dicaprylate ester, a phosphoric acid ester, e.g., tricresylphosphate or triphenylphosphate; an aliphatic dibasic acid ester, e.g., diisobutyladipate, dioctyladipate, dimethylsebacate, dibutylsebacate, dioctylazelate or dibutylmaleate; polyglycidylmethacrylate, triethyl citrate, glycerin triacetyl ester and butyl laurate.

The amount of the plasticizer is preferably about 30% by weight or less based on the total solid content of the image-recording layer.

### <Fine inorganic particle>

The image-recording layer according to the invention may contain fine inorganic particle in order to increase the cured film strength in the image area and to improve the on-machine development property in the non-imaging area.

The fine inorganic particle preferably includes, for example, silica, alumina, magnesium oxide, titanium oxide, magnesium carbonate, calcium alginate and a mixture thereof. Even if the fine inorganic particle has no light to heat converting property, it can be used, for example, for strengthening the film or enhancing interface adhesion due to surface roughening.

The fine inorganic particle preferably has an average particle size from 5 nm to 10 µm and more preferably from 0.5 to 3µm. In the above-described range, it is stably dispersed in the image-recording layer, sufficiently maintains the film strength of the image-recording layer and can form the non-imaging area excellent in hydrophilicity and prevented from stain during printing.

The fine inorganic particle described above is easily available as a commercial product, for example, colloidal silica dispersion.

The amount of the fine inorganic particle added is preferably 20% by weight or less and more preferably 10% by weight or less based on the total solid content of the image-recording layer.

### <Hydrophilic low molecular weight compound>

The image-recording layer according to the invention may contain a hydrophilic low molecular weight compound in order to improve the on-machine development property. The hydrophilic low molecular weight compound includes a water soluble organic compound, for example, a glycol compound, e.g., ethylene glycol, diethylene glycol, triethylene glycol, propylene glycol, dipropylene glycol or tripropylene glycol, or an ether or ester derivative thereof, a polyhydroxy compound, e.g., glycerine or pentaerythritol, an organic amine compound, e.g., triethanol amine, diethanol amine or monoethanol amine, or a salt thereof, an organic sulfonic acid compound, e.g., toluene sulfonic acid or benzene sulfonic acid, or a salt thereof, an organic phosphonic acid compound, e.g., phenyl phosphonic acid, or a salt thereof, an organic carboxylic acid, e.g., tartaric acid, oxalic acid, citric acid, malic acid, lactic acid, gluconic acid or an amino acid, or a salt thereof.

### <Phosphonium compound>

According to the lithographic printing plate precursor of the invention, a phosphonium compound may be added to the image-recording layer and/or protective layer in order to improve the ink receptivity. As the phosphonium compound, a phosphonium compound represented by formula (III) shown below described in JP-A-2006-297907 is exemplified. In formula (III), R₁ to R₄ each independently represents an alkyl group, an alkenyl group, an alkynyl group, a cycloalkyl group, an alkoxy group, an aryl group, an aryloxy group, an alkylthio group or a heterocyclic group each of which may have a substituent or a hydrogen atom. Alternatively, at least two of R₁ to R₄ may be combined with each other to from a ring. X⁻ represents a counter anion. Specific examples of the phosphonium compound represented by formula (iv) include tetrabutylphosphonium chloride, tetra-tert-butylphosphonium bromide, tetraphenylphosphonium bromide, methyltriphenylphosphonium bromide, hexyltriphenylphosphonium bromide, benzyltriphenylphosphonium bromide and allyltriphenylphosphonium bromide.

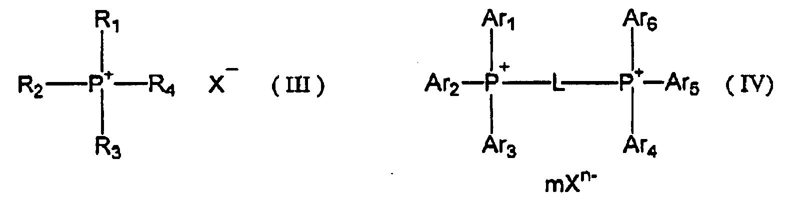

Further, as another preferable phosphonium compound, a compound represented by formula (IV) shown above is exemplified. In formula (IV), Ar₁ to Ar₆ each independently represents an aryl group or a heterocyclic group, L represents a divalent connecting group, Xⁿ⁻ represents a n-valent counter anion, n represents an integer of 1 to 3, and m represents a number satisfying n x m = 2. The aryl group preferably includes, for example, a phenyl group, a naphthyl group, a tolyl group, a xylyl group, a fluorophenyl group, a chlorophenyl group, a bromophenyl group, a methoxyphenyl group, an ethoxyphenyl group, a dimethoxyphenyl group, a methoxycarbonylphenyl group and a dimethylaminophenyl group. The heterocyclic group preferably includes, for example, a pyridyl group, a quinolyl group, a pirimidinyl group, a thienyl group and a furyl group.

L is preferably a connecting group having from 6 to 15 carbon atoms, and more preferably a connecting group having from 6 to 12 carbon atoms.

Preferable examples of the counter anion represented by Xⁿ⁻ include a halogen anion, for example, Cl⁻, Br⁻ or I⁻, a sulfate anion, a carboxylate anion, a sulfate anion, PF₆⁻, BF₄⁻ and a perchlorate anion. Among them, a halogen anion, for example, Cl⁻, Br⁻ or I⁻, a sulfate anion or a carboxylate anion is particularly preferable.

Specific examples of the phosphonium compound represented by formula (IV) are set forth below.

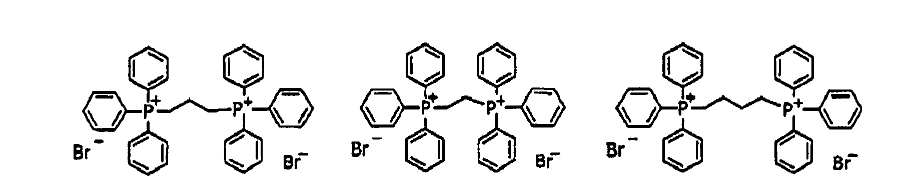

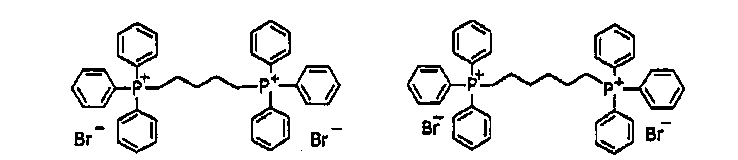

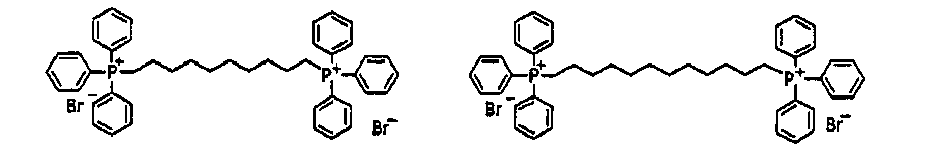

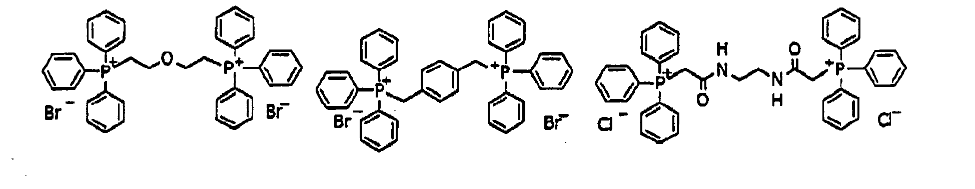

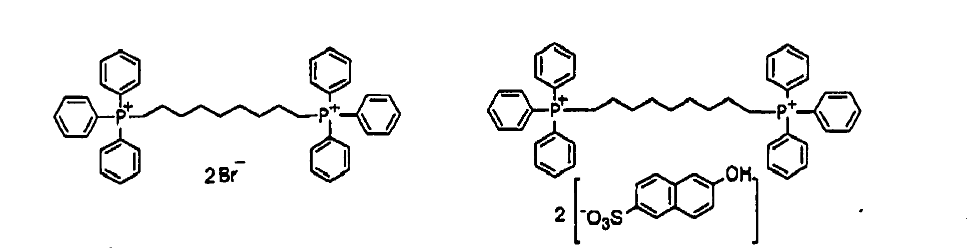

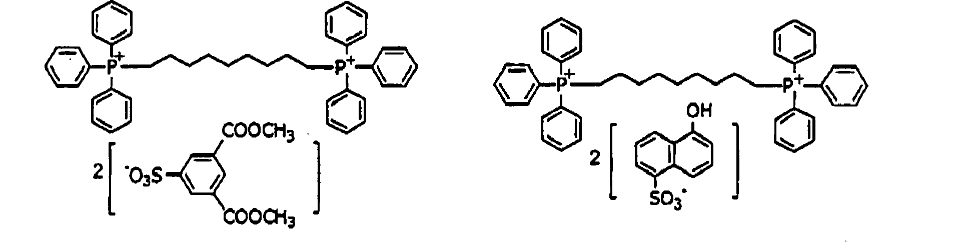

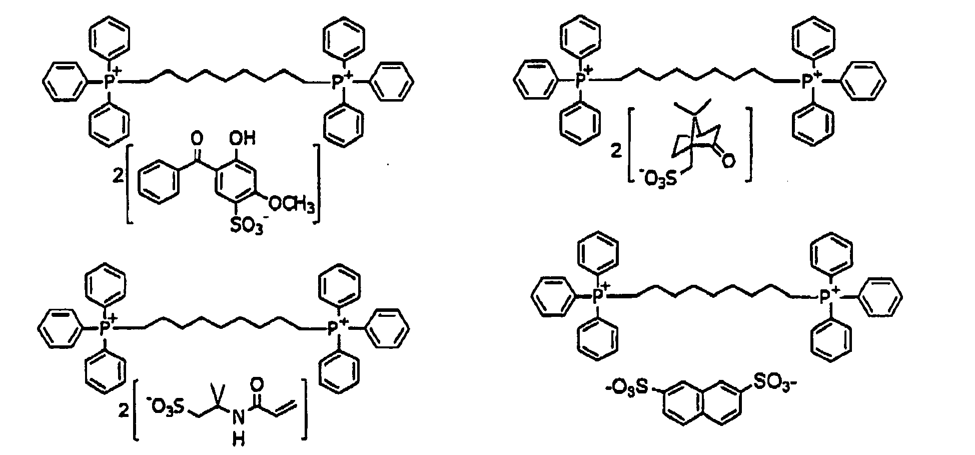

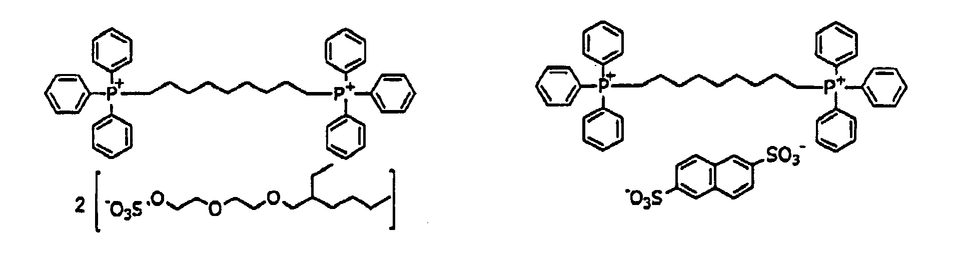

The amount of the phosphonium compound added to the image-recording layer and/or protective layer is preferably from 0.01 to 20% by weight, more preferably from 0.05 to 10% by weight, most preferably from 0.1 to 5% by weight, based on the solid content of each of the layer. In the above-described range, preferable ink receptivity is achieved.

### <(E) Microcapsule or microgel>

In the invention, several embodiments can be employed in order to incorporate the above-described constituting components (A) to (C) of the image-recording layer and other constituting components described above into the image-recording layer. One embodiment is an image-recording layer of molecular dispersion type prepared by dissolving the constituting components in an appropriate solvent to coat as described, for example, in JP-A-2002-287334. Another embodiment is an image-recording layer of microcapsule type prepared by encapsulating all or part of the constituting components into microcapsule to incorporate into the image-recording layer as described, for example, in JP-A-2001-277740 and JP-A-2001-277742. In the image-recording layer of microcapsule type, the constituting components may be present outside the microcapsules. It is a more preferable embodiment of the image-recording layer of microcapsule type that hydrophobic constituting components are encapsulated in microcapsules and hydrophilic components are present outside the microcapsules. A still another embodiment is an image-recording layer containing a crosslinked resin particle, that is, a microgel. The microgel can contain a part of the constituting components inside and/or on the surface thereof. Particularly, an embodiment of a reactive microgel containing the polymerizable compound on the surface thereof is preferable in view of the image-forming sensitivity and printing durability.

In order to achieve more preferable on-machine development property, the image-recording layer is preferably the image-recording layer of microcapsule type or microgel type.

As a method of microencapsulation or microgelation of the constituting components of the image-recording layer, known methods can be used.

Methods of producing the microcapsule include, for example, a method of utilizing coacervation described in U.S. Patents 2,800,457 and 2,800,458, a method of using interfacial polymerization described in U.S. Patent 3,287,154, JP-B-38-19574 and JP-B-42-446, a method of using deposition of polymer described in U.S. Patents 3,418,250 and 3,660,304, a method of using an isocyanate polyol wall material described in U.S. Patent 3,796,669, a method of using an isocyanate wall material described in U.S. Patent 3,914,511, a method of using a urea-formaldehyde-type or urea-formaldehyde-resorcinol-type wall-forming material described in U.S. Patens 4,001,140, 4,087,376 and 4,089,802, a method of using a wall material, for example, a melamine-formaldehyde resin or hydroxycellulose described in U.S. Patent 4,025,445, an in-situ method by monomer polymerization described in JP-B-36-9163 and JP-B-51-9079, a spray drying method described in British Patent 930,422 and U.S. Patent 3,111,407, and an electrolytic dispersion cooling method described in British Patents 952,807 and 967,074, but the invention should not be construed as being limited thereto.

A preferable microcapsule wall used in the invention has three-dimensional crosslinking and has a solvent-swellable property. From this point of view, a preferable wall material of the microcapsule includes polyurea, polyurethane, polyester, polycarbonate, polyamide and a mixture thereof, and polyurea and polyurethane are particularly preferred. Further, a compound having a crosslinkable functional group, for example, an ethylenically unsaturated bond, capable of being introduced into the binder polymer described above may be introduced into the microcapsule wall.

On the other hand, methods of preparing the microgel include, for example, a method of utilizing granulation by interfacial polymerization described in JP-B-38-19574 and JP-B-42-446 and a method of utilizing granulation by dispersion polymerization in a non-aqueous system described in JP-A-5-61214, but the invention should not be construed as being limited thereto.

To the method utilizing interfacial polymerization, known production methods of microcapsule can be applied.

The microgel preferably used in the invention is granulated by interfacial polymerization and has three-dimensional crosslinking. From this point of view, a preferable material to be used includes polyurea, polyurethane, polyester, polycarbonate, polyamide and a mixture thereof, and polyurea and polyurethane are particularly preferred.

The average particle size of the microcapsule or microgel is preferably from 0.01 to 3.0 µm, more preferably from 0.05 to 2.0 µm, and particularly preferably from 0.10 to 1.0 µm In the above-described range, favorable resolution and good preservation stability can be achieved.

### (Formation of image-recording layer)

The image-recording layer according to the invention is formed by dissolving or dispersing each of the necessary constituting components described above in a solvent to prepare a coating solution for image-recording layer and coating the solution on an appropriate support. The solvent used include, for example, ethylene dichloride, cyclohexanone, methyl ethyl ketone, methanol, ethanol, propanol, ethylene glycol monomethyl ether, 1-methoxy-2-propanol, 2-methxyethyl acetate, 1-methoxy-2-propyl acetate, dimethoxyethane, methyl lactate, ethyl lactate, N,N-dimethylacetoamide, N,N-dimethylformamide, tetramethylurea, N-methylpyrrolidone, dimethylsulfoxide, sulfolane, γ-butyrolactone, toluene and water, but the invention should not be construed as being limited thereto.

The solvents may be used individually or as a mixture. The solid content concentration of the coating solution is preferably from 1 to 50% by weight.

The image-recording layer according to the invention may also be formed by preparing plural coating solutions by dispersing or dissolving the same or different components described above into the same or different solvents and conducting repeatedly the coating and drying plural times.

The coating amount of the image-recording layer (solid content) formed on a support after drying may be varied according to the intended purpose but is preferably from 0.3 to 3.0 g/m². In the above-described range, preferable sensitivity and good film property of the image-recording layer can be achieved.

Various methods can be used for the coating. Examples of the coating method include bar coater coating, spin coating, spray coating, curtain coating, dip coating, air knife coating, blade coating and roll coating.

### (Support)

A support for use in the lithographic printing plate precursor according to the invention is not particularly restricted as long as it is a dimensionally stable plate-like material. The support includes, for example, paper, paper laminated with plastic (for example, polyethylene, polypropylene or polystyrene), a metal plate (for example, aluminum, zinc or copper plate), a plastic film (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal film) and paper or a plastic film laminated or deposited with the metal described above. A preferred support includes a polyester film and an aluminum plate. Among them, the aluminum plate is preferred since it has good dimensional stability and is relatively inexpensive.

The aluminum plate includes a pure aluminum plate, an alloy plate comprising aluminum as a main component and containing a trace amount of hetero elements and a thin film of aluminum or aluminum alloy laminated with plastic. The hetero element contained in the aluminum alloy includes, for example, silicon, iron, manganese, copper, magnesium, chromium, zinc, bismuth, nickel and titanium. The content of the hetero element in the aluminum alloy is preferably 10% by weight or less. Although a pure aluminum plate is preferred in the invention, since completely pure aluminum is difficult to be produced in view of the refining technique, the aluminum plate may slightly contain the hetero element. The composition is not specified for the aluminum plate and those materials conventionally known and used can be appropriately utilized.

The thickness of the support is preferably from 0.1 to 0.6 mm, more preferably from 0.15 to 0.4 mm, and still more preferably from 0.2 to 0.3 mm.

In advance of the use of aluminum plate, a surface treatment, for example, roughening treatment or anodizing treatment is preferably performed. The surface treatment facilitates improvement in the hydrophilic property and ensure for adhesion between the image-recording layer and the support. Prior to the roughening treatment of the aluminum plate, a degreasing treatment, for example, with a surfactant, an organic solvent or an aqueous alkaline solution is conducted for removing rolling oil on the surface thereof, if desired.

The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively).

As the method of the mechanical roughening treatment, a known method, for example, ball gaining, brush graining, blast graining or buff graining can be used.

The electrochemical roughening treatment method includes, for example, a method of conducting by passing alternating current or direct current in an electrolyte containing an acid, for example, hydrochloric acid or nitric acid. Also, a method of using a mixed acid described in JP-A-54-63902 can be exemplified.

The aluminum plate subjected to the roughening treatment is subjected, if desired, to an alkali etching treatment using an aqueous solution, for example, of potassium hydroxide or sodium hydroxide and further subjected to a neutralizing treatment, and then subjected to an anodizing treatment for improving the abrasion resistance, if desired.

As the electrolyte used for the anodizing treatment of the aluminum plate, various electrolytes capable of forming porous oxide film can be used. Ordinarily, sulfuric acid, hydrochloric acid, oxalic acid, chromic acid or a mixed acid thereof is used. The concentration of the electrolyte can be appropriately determined depending on the kind of the electrolyte.

Since the conditions for the anodizing treatment are varied depending on the electrolyte used, they cannot be defined commonly. However, it is ordinarily preferred that electrolyte concentration in the solution is from 1 to 80% by weight, liquid temperature is from 5 to 70°C, current density is from 5 to 60 A/dm², voltage is from 1 to 100 V, and electrolysis time is from 10 seconds to 5 minutes. The amount of the anodized film formed is preferably from 1.0 to 5.0 g/m² and more preferably from 1.5 to 4.0 g/m². In the above-described range, good printing durability and good scratch resistance in the non-image area of lithographic printing plate can be achieved.

The aluminum plate subjected to the anodizing treatment is then subjected to a hydrophilizing treatment on the surface thereof, if desired. The hydrophilizing treatment includes an alkali metal silicate method described in U.S. Patents 2,714,066, 3,181,461, 3,280,734 and 3,902,734. In the method, the support is subjected to an immersion treatment or an electrolytic treatment in an aqueous solution, for example, of sodium silicate. In addition, the hydrophilizing treatment includes, for example, a method of treating with potassium fluorozirconate described in JP-B-36-22063 and a method of treating with polyvinylphosphonic acid described in U.S. Patents 3,276,868, 4,153,461 and 4,689,272.

The support preferably has a center line average roughness of 0.10 to 1.2 µm. In the above-described range, good adhesion to the image-recording layer, good printing durability, and good resistance to stain can be achieved.

Further, color density of the support is preferably from 0.15 to 0.65 in terms of a reflection density value. In the above-described range, good image-forming property due to prevention of halation at the image exposure and good plate inspection property after development can be achieved.

### (Backcoat layer)

After applying the surface treatment or forming an undercoat layer to the support, a backcoat layer can be provided on the back surface of the support, if desired.

The backcoat layer preferably used includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an alkoxy compound of silicon, for example, Si(OCH₃)₄, Si(OC₂H₅)₄, Si(OC₃H₇)₄, or Si(OC₄H₉)₄ is preferred since the starting material is inexpensive and easily available.

### (Undercoat layer)

In the lithographic printing plate precursor according to the invention, an undercoat layer can be provided between the support and the image-recording layer, if desired. The undercoat layer makes removal of the image-recording layer from the support in the unexposed area easy so that the on-machine development property can be improved. Further, it is advantageous that in the case of infrared laser exposure, since the undercoat layer acts as a heat insulating layer, heat generated upon the exposure does not diffuse into the support and is efficiently utilized so that increase in sensitivity can be achieved.

As a compound for the undercoat layer (undercoat compound), specifically, for example, a silane coupling agent having an addition-polymerizable ethylenic double bond reactive group described in JP-A-10-282679 and a phosphorus compound having an ethylenic double bond reactive group described in JP-A-2-304441 are preferably exemplified.

As a most preferable undercoat layer, an embodiment containing a polymer resin obtained by copolymerization of a monomer having an adsorbing group, a monomer having a hydrophilic group and a monomer having a crosslinkable group is exemplified.

The essential component in the polymer resin for use in the undercoat layer is an adsorbing group to the hydrophilic surface of the support. Whether the adsorptivity to the hydrophilic surface of the support is present or not can be judged, for example, by the following method.

Specifically, a test compound is dissolved in a solvent in which the test compound is easily soluble to prepare a coating solution, and the coating solution is coated and dried on a support so as to have the coating amount after drying of 30 mg/m². After thoroughly washing the support coated with the test compound using the solvent in which the test compound is easily soluble, the residual amount of the test compound that has not been removed by the washing is measured to calculate the adsorption amount to the support. For measuring the residual amount, the amount of the residual test compound may be directly determined, or it may be calculated from the amount of the test compound dissolved in the washing solution. The determination for the compound can be performed, for example, by fluorescent X-ray measurement, reflection spectral absorbance measurement or liquid chromatography measurement. The compound having the adsorptivity to support means a compound that remains by 1 mg/m² or more even after conducting the washing treatment described above.

The adsorbing group to the hydrophilic surface of the support is a functional group capable of forming a chemical bond (for example, an ionic bond, a hydrogen bond, a coordinate bond or a bond with intermolecular force) with a substance (for example, metal or metal oxide) or a functional group (for example, a hydroxy group) present on the surface of the support. The adsorbing group is preferably an acid group or a cationic group.

The acid group preferably has an acid dissociation constant (pKa) of 7 or less. Examples of the acid group include a phenolic hydroxy group, a carboxyl group, -SO₃H, -OSO₃H, -PO₃H₂, -OPO₃H₂, -CONHSO₂-, -SQ₂NHSO₂- and -COCH₂COCH₃. Among them, -OPO₃H₂ and -PO₃H₂ are particularly preferred. The acid group may be the form of a metal salt.

The cationic group is preferably an onium group. Examples of the onium group include an ammonium group, a phosphonium group, an arsonium group, a stibonium group, an oxonium goup, a sulfonium goup, a selenonium group, a stannonium group and iodonium group. Among them, the ammonium group, phosphonium group and sulfonium group are preferred, the ammonium group and phosphonium group are more preferred, and the ammonium group is most preferred.

Particularly preferable examples of the monomer having the adsorbing group include compounds represented by the following formula (V) or (VI):

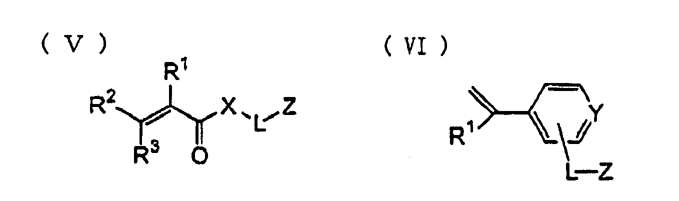

In formula (V) or (VI), R¹, R² and R³ each independently represents a hydrogen atom, halogen atom or an alkyl group having from 1 to 6 carbon atoms. R¹ and R² and R³ each independently represents preferably a hydrogen atom or an alkyl group having from 1 to 6 carbon atoms, more preferably a hydrogen atom or an alkyl group having from 1 to 3 carbon atoms and, most preferably a hydrogen atom or a methyl group. It is particularly preferred that R² and R³ each represents a hydrogen atom. Z represents a functional group adsorbing to the hydrophilic surface of the support.

In formula (V), X represents an oxygen atom (-O-) or imino group (-NH-). Preferably, X represents an oxygen atom.

In formula (V), L represents a divalent connecting group. It is preferred that L represents a divalent aliphatic group (for example, an alkylene group, a substituted alkylene group, an alkenylene group, a substituted alkenylene group, an alkinylene group or a substituted alkinylene group), a divalent aromatic group (for example, an arylene group or a substituted arylene group), a divalent heterocyclic group or a combination of each of the groups described above with an oxygen atom (-O-), a sulfur atom (-S-), an imino group (-NH-), a substituted imino group (-NR-, wherein R represents an aliphatic group, an aromatic group or a heterocyclic group) or a carbonyl group (-CO-).

The aliphatic group may form a cyclic structure or a branched structure. The number of carbon atoms of the aliphatic group is preferably from 1 to 20, more preferably from 1 to 15, and most preferably from 1 to 10. It is preferred that the aliphatic group is a saturated aliphatic group rather than an unsaturated aliphatic group. The aliphatic group may have a substituent. Examples of the substituent include a halogen atom, a hydroxy group, an aromatic group and a heterocyclic group.

The number of carbon atoms of the aromatic group is preferably from 6 to 20, more preferably from 6 to 15, and most preferably from 6 to 10. The aromatic group may have a substituent. Examples of the substituent include a halogen atom, a hydroxy group, an aliphatic group, an aromatic group and a heterocyclic group.

It is preferred that the heterocyclic group has a 5-membered or 6-membered ring as the heterocyclic ring. Other heterocyclic ring, an aliphatic ring or an aromatic ring may be condensed to the heterocyclic ring. The heterocyclic group may have a substituent. Examples of the substituent include a halogen atom, a hydroxy group, an oxo group (=O), a thio group (=S), an imino group (=NH), a substituted imino group (=N-R, where R represents an aliphatic group, an aromatic group or a heterocyclic group), an aliphatic group, an aromatic group and a heterocyclic group.

It is preferred that L represents a divalent connecting group containing a plurality of polyoxyalkylene structures. It is more preferred that the polyoxyalkylene structure is a polyoxyethylene structure. Specifically, it is preferred that L contains -(OCH₂CH₂)ₙ- (n is an integer of 2 or more).

In the formula (VI), Y represents a carbon atom or a nitrogen atom. In the case where Y is a nitrogen atom and L is connected to Y to form a quaternary pyridinium group, Z is not mandatory and may be a hydrogen atom, because the quaternary pyridinium group itself exhibits the adsorptivity. L represents a divalent connecting group same as that defined in formula (V) or a single bond

The adsorptive functional group is the same as that described above.

Representative examples of the compound represented by formula (V) or (VI) are set forth below.

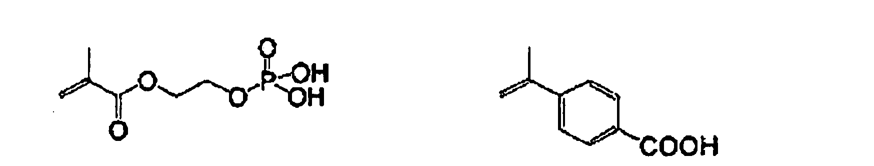

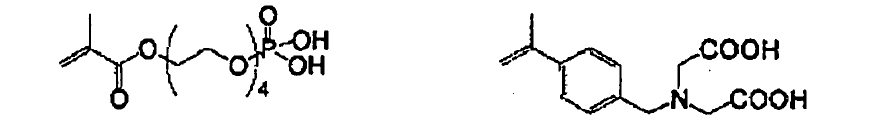

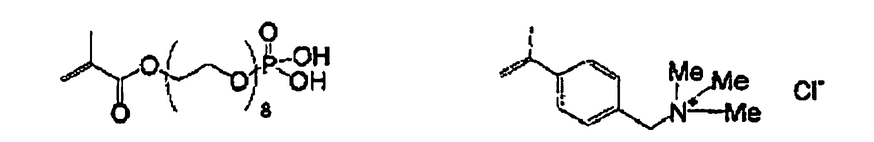

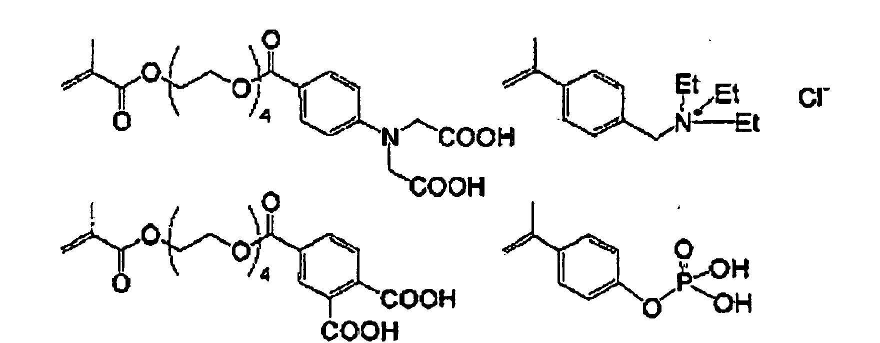

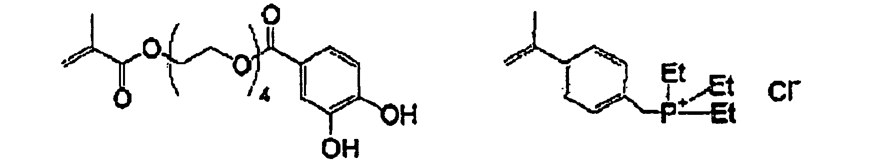

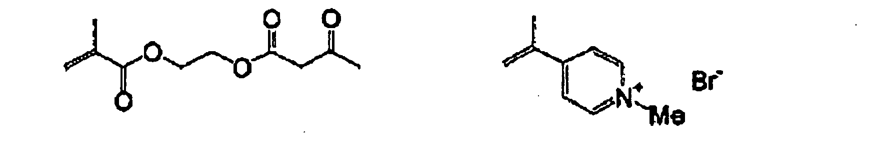

The hydrophilic group included in the polymer resin for the undercoat layer for use in the invention preferably includes, for example, a hydroxy goup, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfo group or a phosphoric acid group. Among them, a monomer having a sulfo group exhibiting a highly hydrophilic property is preferable. Specific examples of the monomer having a sulfo group include sodium salt or an amine salt of methallyloxybenzenesulfonic acid, allyloxybenzenesulfonic acid, allylsulfonic acid, vinylsulfonic acid, p-styrenesulfonic acid, methallylsulfonic acid, acrylamide-tert-butylsulfonic acid, 2-acrylamido-2-methylpropanesulfonic acid and (3-acryloyloxypropyl)butylsulfonic acid. Among them, sodium salt of 2-acrylamido-2-methylpropanesulfonic acid is preferable in view of the hydrophilic property and handling property in the synthesis thereof.

It is preferred that the polymer resin for the undercoat layer according to the invention has a crosslinking property. A crosslinkable group acts to improve the adhesion to the image area. In order to impart the crosslinking property to the polymer resin for the undercoat layer, introduction of a crosslinkable functional group, for example, an ethylenically unsaturated bond into the side chain of the polymer or introduction by formation of a salt structure between a polar substituent of the polymer resin and a compound containing a substituent having a counter charge to the polar substituent of the polymer resin and an ethylenically unsaturated bond is used.

Examples of the polymer having an ethylenically unsaturated bond in the side chain thereof include a polymer of an ester or amide of acrylic acid or methacrylic acid, which is a polymer wherein the ester or amide residue (R in -COOR or -CONHR) has an ethylenically unsaturated bond.

Specific examples of the residue (R described above) having an ethylenically unsaturated bond, ester residue and amido residue are same as those described for the binder polymer having a crosslinkable group of the image-recording layer above.

As a monomer having a crosslinkable group for the polymer resin for undercoat layer, an ester or amide of acrylic acid or methacrylic acid having the above-described crosslinkable group is preferred.

The content of the crosslinkable group in the polymer resin for undercoat layer (content of the radical polymerizable unsaturated double bond determined by iodine titration) is preferably from 0.1 to 10.0 mmol, more preferably from 1.0 to 7.0 mmol, and most preferably from 2.0 to 5.5 mmol, based on 1 g of the polymer resin. In the above-described range, preferable compatibility between the sensitivity and stain resistance and good preservation stability can be achieved.

The weight average molecular weight of the polymer resin for undercoat layer is preferably 5,000 or more, more preferably from 10,000 to 300,000. The number average molecular weight of the polymer resin is preferably 1,000 or more, more preferably from 2,000 to 250,000. The polydispersity (weight average molecular weight/number average molecular weight) thereof is preferably from 1.1 to 10.

The polymer resin for undercoat layer may be any of a random polymer, a block polymer, a graft polymer and the like, and is preferably a random polymer.

The polymer resins for undercoat layer may be used individually or in a mixture of two or more thereof Also, two or more of the compounds having a functional group adsorbing to the hydrophilic surface of the support may be used together. A coating solution for undercoat layer is obtained by dissolving the polymer resin for undercoat layer in an organic solvent (for example, methanol, ethanol, acetone or methyl ethyl ketone) and/or water. The coating solution for undercoat layer may contain an infrared absorbing agent.

In order to coat the coating solution for undercoat layer on the support, various methods can be used. Examples of the method include bar coater coating, spin coating, spray coating, curtain coating, dip coating, air knife coating, blade coating and roll coating.

The coating amount (solid content) of the undercoat layer is preferably from 0.1 to 100 mg/m², and more preferably from 1 to 30 mg/m².

### (Exposure)

As a light source for exposure of the lithographic printing plate precursor according to the invention, known light sources can be used without limitation. A preferred wavelength of the light source is from 300 to 1,200 nm. Specifically, various kinds of lasers preferably used as the light source, and among them, a semiconductor laser emitting an infrared ray having a wavelength of 760 to 1,200 nm is preferably used.

The exposure mechanism used may be any of inner surface drum type, outer surface drum type and flat bed type can be used.

Further, other exposure light sources used for the lithographic printing plate precursor according to the invention include, for example, a super-high pressure, high pressure, medium pressure or low pressure mercury lamp, a chemical lamp, a carbon arc lamp, a xenon lamp, a metal halide lamp, a variety of visible or ultraviolet laser lamps, a fluorescent lamp, a tungsten lamp and sunlight.

### (Printing method)

In the lithographic printing method according to the invention, the lithographic printing plate precursor of the invention is exposed imagewise by an infrared laser and then, without undergoing the development processing step, oily ink and an aqueous component are supplied to the lithographic printing plate precursor to perform printing.

More specifically, there are illustrated a method wherein the lithographic printing plate precursor is exposed by an infrared laser and without undergoing the development processing step, mounted on a printing machine to perform printing and a method wherein the lithographic printing plate precursor is mounted on a printing machine, exposed by an infrared laser on the printing machine to perform printing without undergoing the development processing step.

After the imagewise exposure of the lithographic printing plate precursor by an infrared laser, when an aqueous component and oily ink are supplied to perform printing without undergoing the development processing step, for example, a wet development processing step, in the exposed area of the image-recording layer, the image-recording layer cured by the exposure forms the oily ink receptive area having an oleophilic surface. On the other hand, in the unexposed area, the uncured image-recording layer is removed by dissolution or dispersion with the aqueous component and/or oily ink supplied to reveal a hydrophilic surface of support in the area.

As a result, the aqueous component is adhered on the revealed hydrophilic surface, the oily ink is adhered to the exposed area of the image-recording layer, and thus printing is initiated. While either the aqueous component or the oily ink may be supplied at first to the plate surface, it is preferred to supply the oily ink at first in view of preventing the aqueous component from contamination with the image-recording layer of the unexposed area. As the aqueous component and oily ink, dampening water and printing ink for conventional lithographic printing are used respectively.

Thus, the lithographic printing plate precursor is subjected to the on-machine development on an offset printing machine and used as it is for printing a large number of sheets.

### EXAMPLES

The present invention will be described in more detail with reference to the following examples, but the invention should not be construed as being limited thereto.

### [I] Synthesis example of polymer latex

Analysis procedures for use in the synthesis example of polymer latex are as follows.

### (A) Amount of agglomerate occurred at polymerization

After the completion of the emulsion polymerization, the whole amount of a latex in a polymerization vessel was filtered by a metal net of 400 mesh, the solid remaining on the metal net was washed with water, dried and the weight thereof was measured, and a weight ratio of the remaining solid to the monomer mixture used for the polymerization was determined.

### (B) Stability of latex

The latex synthesized was allowed to stand at normal temperature for 3 days and whether precipitate occurred or not was visually observed.

### (C) Particle size

The particle size was measure in a conventional manner using a laser diffraction/scatter system particle size distribution measuring apparatus, LA-910 (produced by Horiba, Ltd.).

### (D) Measurement of remaining monomer amount

The presence or absence of the unreacted monomer was confirmed or the amount of the unreacted monomer was measured by NMR (solvent: deuterated DMSO).

### (E) Measurement of solid content amount

The latex liquid was weighed in an aluminum pan and vacuum-dried at 130°C for 2 hours. From the change of weight after the drying, the solid content amount was calculated.

### [Reference Example 1] Synthesis Example 1 of Polymer Latex

In a 200 ml three-necked flask equipped with a mechanical stirrer were added 85 g of water, 0.3 g of sodium dodecylsulfate (SDS) and 5.0 g of acrylonitrile to completely dissolve. After substitution with nitrogen gas in the system, the nitrogen gas was flowed at a flow rate of 10 ml/min. Then, the temperature was raised to 70°C and an aqueous solution of potassium persulfate (including 0.27 g of potassium persulfate and 10 g of water) was dropwise added over a period of 2 hours while stirring at a rotation speed of 300 rpm. After the completion of the dropwise addition, the stirring was continued at 70°C for 3 hours. Then, the temperature was raised to 80°C and the flow rate of nitrogen gas was increased to 100 ml/min, followed by stilling for 2 hours. The acrylonitrile distilled off was trapped by a Dean-Stark apparatus.

The solid content amount, amount of agglomerate occurred at polymerization, stability of latex, particle size and remaining monomer amount are shown in Table 1.

### [Reference Examples 2 to 5] Synthesis Examples 2 to 5 of Polymer Latex

The emulsion polymerization was conducted in the same manner as in Example 1 except for changing the kind and amount of the copolymerizable monomer and the kind of the protective colloid as shown in Table 1 respectively. The results are shown in Table 1.

### [Reference Comparative Example 1] Comparative Synthesis Example 1 of Polymer Latex

The same procedure as described in Example 1 was carried out but the reaction was terminated after the stirring at 70°C for 3 hours. The results are shown in Table 1. The acrylonitrile was insufficient in the polymerizability in the emulsion polymerization and a large amount of the unreacted monomer remained.

### [Reference Comparative Example 2] Comparative Synthesis Example 2 of Polymer Latex

In a 200 ml three-necked flask equipped with a mechanical stirrer were added 85 g of water, 0.3 g of sodium dodecylsulfate (SDS) and 30.0 g of acrylonitrile. After substitution with nitrogen gas in the system, the nitrogen gas was flowed at a flow rate of 10 ml/min. Then, the temperature was raised to 70°C and an aqueous solution of potassium persulfate (KPS) (including 0.90 g of potassium persulfate and 20 g of water) was dropwise added over a period of 2 hours while stirring at a rotation speed of 300 rpm. After the completion of the dropwise addition, the stirring was continued at 70°C for 3 hours. At that stage, the mixture of the polymerization reaction was overall agglomerated (theoretical solid content amount = 30% by weight).

### [Reference Comparative Example 3] Comparative Synthesis Example 3 of Polymer Latex

The emulsion polymerization was carried out except for changing the amount of potassium persulfate to 0.6 g. As a result, at the stage of the completion of the dropwise addition of the aqueous potassium persulfate solution, the mixture of the polymerization reaction was overall agglomerated (amount of potassium persulfate to total monomer = theoretical solid content amount = 12% by weight).

As shown in Table 1, a stable latex of acrylonitrile homopolymer and a polymer of high acrylonitrile content can be obtained even though it is heretofore believed to be impossible to obtain a stable aqueous latex and there is no report about it at all.

**TABLE 1**

| | Reference Example 1 | Reference Example 2 | Reference Example 3 | Reference Example 4 | Reference Example 5 | Reference Comparative Example 1 | Reference Comparative Example 2 | Reference Comparative Example 3 |
|---|---|---|---|---|---|---|---|---|
| Amount of acrylonitrile (g) | 5.00 | 10.00 | 5.00 | 4.75 | 5.28 | 5.00 | 30.00 | 5.00 |
| Copolymerizable Monomer and Amount(g) | None 0 | None 0 | None 0 | Divinyl benzene 0.25 | SEM 0.0865 | None 0 | None 0 | None 0 |
| Amount of Polymerization Initiator (g) | 0.27 | 0.27 | 0.27 | 0.27 | 0.27 | 0.27 | 0.27 | 0.60 |
| Protective Colloid | SDS | SDS | PVA-124 | SDS | SDS | SDS | SDS | SDS |
| Solid Content (%) | 4.76 | 9.53 | 4.70 | 4.38 | 4.82 | 3.88 | - | - |
| Distilling Off Step | Yes | Yes | Yes | Yes | Yes | No | No | No |
| Amount of Agglomerate Occurred at Polymerization | 0.00 | 0.00 | 0.00 | 0.00 | 0.00 | 0.00 | 30.0 | 30.0 |
| Stability of Latex | No precipitate | No precipitate | No precipitate | No precipitate | No precipitate | No precipitate | Precipitate existed, agglomerated overall | Precipitate existed, agglomerated overall |
| Particle Size (nm) | 125 | 130 | 140 | 140 | 172 | 150 | - | - |
| Remaining Monomer Amount (%) | 0.00 | 0.00 | 0.00 | 0.00 | 0.00 | 22.40 | - | - |

### [II-1] Preparation example of lithographic printing plate precursor

A synthesis example of a polymer latex used for the preparation of lithographic printing plate precursor is described below.

### (Synthesis Example 1)

In a 200 ml three-necked flask equipped with a mechanical stirrer were added 85 g of water, 0.3 g of sodium dodecylsulfate (SDS) and 5 g of acrylonitrile. Then, nitrogen gas was flowed at a flow rate of 10 ml/min in the system and the temperature was raised to 70°C. An aqueous solution (10 ml) containing 0.27 g potassium persulfate (KPS) was dropwise added at 70°C over a period of 2 hours, and after the completion of the dropwise addition, the stirring was further continued at 70°C for one hour to obtain a latex (solid content: 4.16% by weight).

### (Synthesis Example 2)

A latex was obtained in the same manner as in Synthesis Example 1 except for changing the polymerizable monomer to 4.75 g of acrylonitrile and 0.25 g of divinyl benzene (solid content: 4.50% by weight).

### (Synthesis Example 3)

A latex was obtained in the same manner as in Synthesis Example 1 except for changing the polymerizable monomer to 4.75 g of acrylonitrile and 0.25 g of methyl methacrylate (solid content: 4.70% by weight).

### (Comparative Synthesis Example 1)

A latex was obtained in the same manner as in Synthesis Example 1 except for changing the polymerizable monomer to 5.00 g of ethyl methacrylate (solid content: 5.34% by weight).

### [Example 1]

### (1) Preparation of support

An aluminum plate (material: JIS 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm³) of pumice having a median size of 25 µm, followed by thorough washing with water. The plate was etched by immersing in a 25% by weight aqueous sodium hydroxide solution of 45°C for 9 seconds, washed with water, then immersed in a 20% by weight aqueous nitric acid solution at 60°C for 20 seconds, and washed with water. The etching amount of the grained surface was about 3g/m².

Then, using an alternating current of 60 Hz, an electrochemical roughening treatment was continuously carried out on the plate. The electrolyte used was a 1% by weight aqueous nitric acid solution (containing 0.5% by weight of aluminum ion) and the electrolyte temperature was 50°C. The electrochemical roughening treatment was conducted using an alternating current source, which provides a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm² in terms of the peak value of the electric current, and 5% of the electric current flowing from the electric source was divided to the auxiliary anode. The quantity of electricity in the nitric acid electrolysis was 175 C/dm² in terms of the quantity of electricity when the aluminum plate functioned as an anode. The plate was then washed with water by spraying.

The plate was further subjected to an electrochemical roughening treatment in the same manner as in the nitric acid electrolysis above using as an electrolyte, a 0.5% by weight aqueous hydrochloric acid solution (containing 0.5% by weight of aluminum ion) having temperature of 50°C and under the condition that the quantity of electricity was 50 C/dm² in terms of the quantity of electricity when the aluminum plate functioned as an anode. The plate was then washed with water by spraying. The plate was subjected to an anodizing treatment using as an electrolyte, a 15% by weight aqueous sulfuric acid solution (containing 0.5% by weight of aluminum ion) at a current density of 15 A/dm² to form a direct current anodized film of 2.5 g/m², washed with water and dried. The center line average roughness (Ra) of the substrate was measured using a stylus having a diameter of 2 µm and it was found to be 0.51 µm. Moreover, Undercoat solution (1) shown below was coated on the substrate so as to have a dry coating amount of 6 mg/m² to prepare a support.

| | |
|---|---|
| Undercoat solution (1) | |
| Undercoat compound (1) shown below (weight average molecular weight: 60,000) | 0.017 g |
| Methanol | 9.00 g |
| Water | 1.00 g |

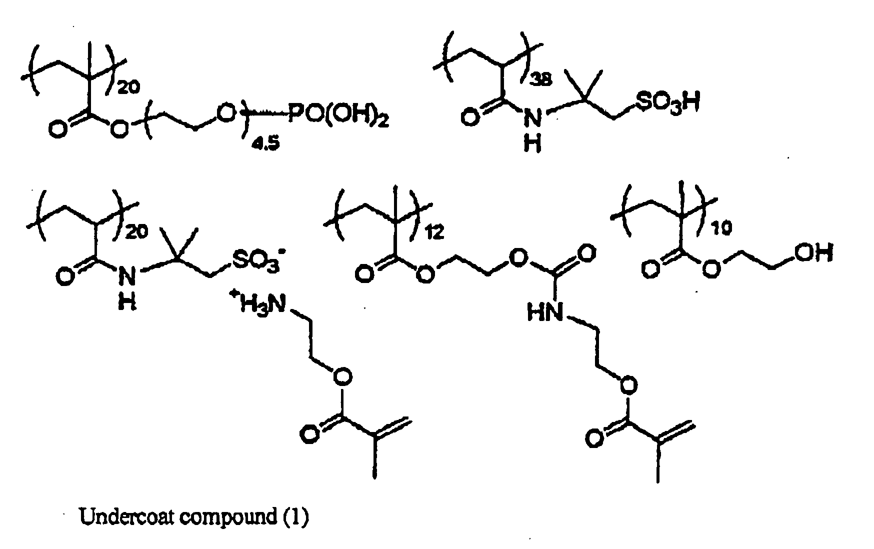

### (2) Formation of image-recording layer and protective layer

A coating solution for image-recording layer having the composition shown below was coated on the above-described support provided with the undercoat layer by a bar and dried in an oven at 100°C for 60 seconds to form an image-recording layer having a dry coating amount of 1.0 g/m². Subsequently, a coating solution for protective layer having the composition shown below was coated on the image-recording layer by a bar and dried in an oven at 120°C for 60 seconds to form a protective layer having a dry coating amount of 0.160 g/m², thereby preparing Lithographic printing plate precursor (1).

The coating solution for image-recording layer was prepared by mixing Photosensitive solution shown below with Microgel solution (1) shown below just before the coating, followed by stirring.

### <Photosensitive solution>

| | |
|---|---|
| (D) Binder polymer (1) shown below | 0.177 g |
| | |
| (A) Radical generator (Compound A-9 of formula (I)) | 0.142 g |
| | |
| (B) Infrared absorbing agent (1) shown below | 0.0308 g |
| (C) Polymerizable compound (Aronics M-215, produced by Toagosei Co., Ltd.) | 0.319 g |
| | |
| Phosphonium compound (1) shown below | 0.035 g |
| | |
| Fluorine-based surfactant (1) shown below | 0.004 g |
| | |
| Anionic surfactant (Pionine A-24-EA, produced by Takemoto Oil and Fat Co., Ltd., an aqueous 40% by weight solution) | 0.125 g |
| | |
| Methyl ethyl ketone | 2.554 g |
| | |
| 1-Methoxy-2-propanol | 7.023 g |
| | |
| Microgel solution (1) shown below | 1.800 g |
| | |
| Water | 1.678 g |

### Preparation of Microgel (1)

An oil phase component was prepared by dissolving 10.0 g of adduct of trimethylol propane and xylene diisocyanate (Takenate D-110N, produced by Mitsui Takeda Chemical Co., Ltd., a 75% by weight ethyl acetate solution), 6.00 g of a polymerizable monomer (Aronics M-215, produced by Toagosei Co., Ltd.) and 0.12 g of Pionine A-41C (produced by Takemoto Oil and Fat Co., Ltd.) in 16.67 g of ethyl acetate. As an aqueous phase component, 37.5 g of a 4% by weight aqueous solution of PVA-205 was prepared. The oil phase component and the aqueous phase component were mixed and emulsified using a homogenizer at 12,000 rpm for 10 minutes. The resulting emulsion was added to 25 g of distilled water and stirred at room temperature for 30 minutes and then at 40°C for 2 hours. The thus-obtained liquid was diluted using distilled water so as to have the solid concentration of 21% by weight to prepare Microgel (1). The average particle size of the particle in Microgel (1) was 0.23 µm.

Structures of the respective compounds used in the above-described photosensitive solution are shown below.

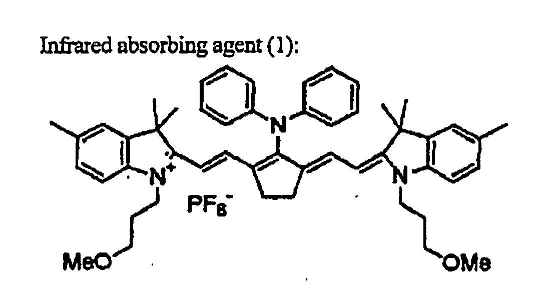

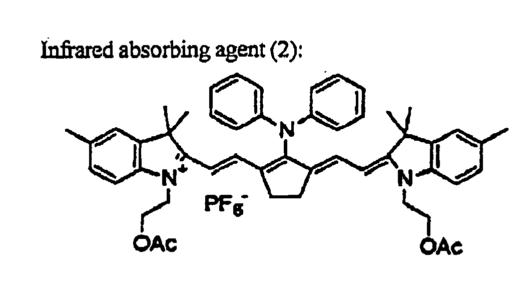

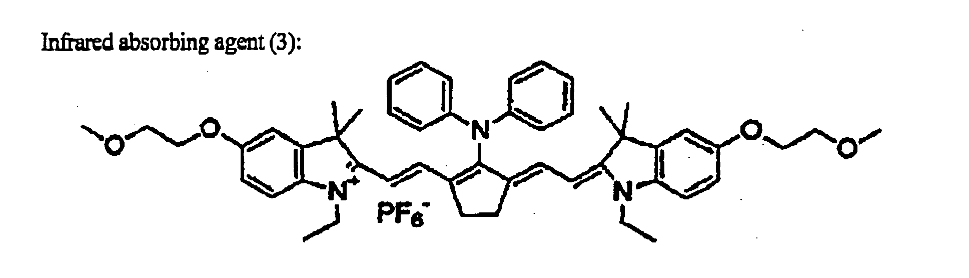

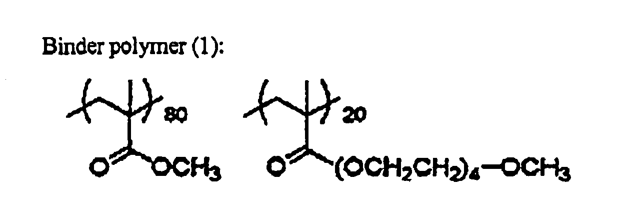

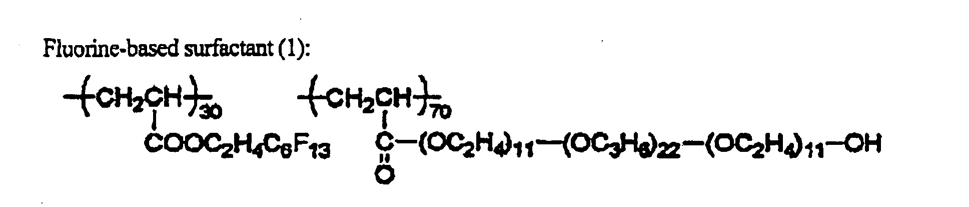

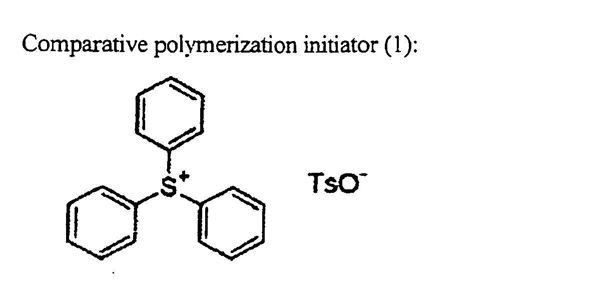

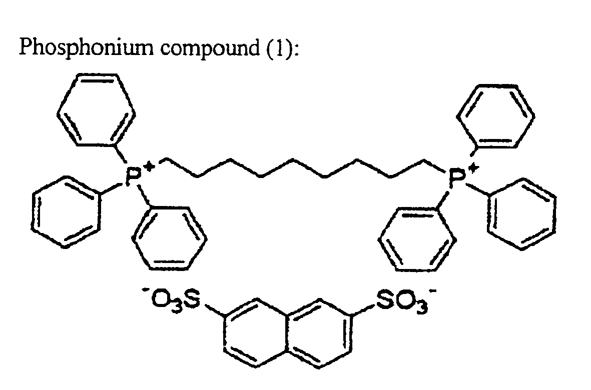

### <Coating solution for protective layer>

| | |
|---|---|
| Latex of Synthesis Example 9 | 4.01 g |
| | |
| Nonionic surfactant (EMALEX 710, produced by Nihon-Emulsion Co., Ltd.) | 0.013 g |
| | |
| Ion-exchanged water | 6.0 g |

### [Examples 2 to 9]

Lithographic printing plate precursors (2) to (9) were prepared in the same manner as in Example 1 except for changing the kind and amount of latex used in the coating solution for protective layer and the dry coating amount of the protective layer to those shown in Table 2 below, respectively.

### [Comparative Example 1]

A lithographic printing plate precursor (R1) was prepared in the same manner as in Example 1 except for changing the coating solution for protective layer to the coating solution for protective layer shown below.

### <Coating solution for protective layer of Comparative Example 1>

| | |
|---|---|
| Dispersion of mica (1) shown below | 1.5 g |
| | |
| Polyvinyl alcohol (PVA-105, saponification degree: 98.5% by mole, polymerization degree: 500, produced by Kuraray Co., Ltd.) | 0.06 g |
| | |
| Polyvinylpyrrolidone (K30, molecular weight Mw: 40,000, produced by Tokyo Chemical Industry Co., Ltd.) | 0.01 g |
| | |
| Copolymer of vinylpyrrolidone and vinyl acetate (LUVITEC VA64W, copolymerization ratio = 6/4, produced by ISP Co., Ltd.) | 0.01 g |
| | |
| Nonionic surfactant (EMALEX 710, produced by Nihon-Emulsion Co., Ltd.) | 0.01 g |
| | |
| Ion-exchanged water | 6.0 g |

### Preparation of Dispersion of mica (1)

To 193.6 g of ion-exchanged water was added 6.4 g of synthetic mica (Somasif ME-100, produced by CO-OP Chemical Co., Ltd.) and the mixture was dispersed using a homogenizer until an average particle size (according to a laser scattering method) became 3 µm to prepare Dispersion of mica (1). The aspect ratio of the mica thus-dispersed was 100 or more.

### [Comparative Example 2]

A lithographic printing plate precursor (R2) was prepared in the same manner as in Example 1 except for changing Latex of Synthesis Example 1 in the coating solution for protective layer to Latex of Comparative Synthesis Example 1.

### [II-2] Evaluation of lithographic printing plate precursor

Each of Lithographic printing plate precursors (1) to (9), (R1) and (R2) obtained was exposed by Trendsetter 3244VX (produced by Creo Co.) equipped with a water-cooled 40 W infrared semiconductor laser under the conditions of output of 11.7W, a rotational number of an outer surface drum of 250 rpm and resolution of 2,400 dpi., and then the on-machine development property, ink-receptive property and printing durability were evaluated in the manner described below. The results obtained are shown in Table 2 below.

### (Evaluation of on-machine development property)

The exposed lithographic printing plate precursor was mounted on a plate cylinder of a printing machine (SOR-M, produced by Heidelberg Co.) without conducting development processing. After supplying dampening water (EU-3 (etching solution, produced by Fuji Film Co., Ltd.)/water/isopropyl alcohol = 1/89/10 (volume ratio)) and ink (TRANS-G (N) black ink, produced by Dainippon Ink and Chemicals, Inc.), printing was conducted at a printing speed of 6,000 sheets per hour. A number of printing papers (on-machine development property) required until reaching a state where the ink was not transferred in the unexposed area (non-image area) of the image-recording layer was determined. As the number of printing papers is small, it is evaluated that the on-machine development property is more excellent.

### (Evaluation of ink-receptive property)

As increase in a number of printing papers, the ink-receptive property was gradually degrades to cause decrease of ink density on printing paper due to the ease of removal of the protective layer, the ease of removal of the image-recording layer or the segregation in the layer and/or dissolution outside the layer of the components in the protective layer or image-recording layer. A number of printing papers obtained until the ink density (reflection density) decreased by 0.01 from that at the initiation of printing was determined to evaluate the ink-receptive property. As the number of the printing papers is large, it is evaluated that the ink-receptive property is more excellent.

### (Evaluation of printing durability)

The printing was further continued and as increase in a number of printing papers, the image-recording layer was gradually abraded to cause degradation of the ink-receptive property resulting in decrease of ink density on printing paper. A number of printing papers obtained until the ink density (reflection density) decreased by 0.1 from that at the initiation of printing was determined to evaluate the printing durability. As the number of the printing papers is large, it is evaluated that the printing durability is more excellent.

From the results shown in Table 2, the lithographic printing plate precursor to which the protective layer according to the invention is applied is excellent in the on-machine development property, ink-receptive property and printing durability and exhibits all sorts of practically sufficient performances as the lithographic printing plate.

**TABLE 2**

| | Latex used in Coating Solution for Protective Layer | Amount of Latex (g) | Dry Coating Amount (g/m²) | Result of Evaluation | | |
|---|---|---|---|---|---|---|
| | | | | On-machine Development Property (sheets) | Ink-receptive Property (sheets) | Printing Durability (sheets) |
| Example 1 | Synthesis Example 1 | 4.01 | 0.160 | 20 | 11,000 | 13,000 |
| Example 2 | Synthesis Example 1 | 6.39 | 0.255 | 25 | 11,000 | 13,000 |
| Example 3 | Synthesis Example 1 | 8.69 | 0.347 | 35 | 11,000 | 12,000 |
| Example 4 | Synthesis Example 2 | 4.01 | 0.160 | 15 | 12,000 | 14,000 |
| Example 5 | Synthesis Example 2 | 6.39 | 0.255 | 20 | 12,000 | 15,000 |
| Example 6 | Synthesis Example 2 | 8.69 | 0.347 | 25 | 12,000 | 14,000 |
| Example 7 | Synthesis Example 3 | 4.01 | 0.160 | 25 | 10,000 | 12,000 |
| Example 8 | Synthesis Example 3 | 6.39 | 0.255 | 30 | 10,000 | 12,000 |
| Example 9 | Synthesis Example 3 | 8.69 | 0.347 | 35 | 10,000 | 11,000 |
| Comparative Example 1 | No latex (Coating Solution for Protective Layer of Comparative Example 1) | 4.01 | 0.160 | 75 | 1,000 | 4,000 |
| Comparative Example 2 | Comparative Synthesis Example 1 | 4.01 | 0.160 | 200 | 2,000 | 4,000 |

This application is based on Japanese Patent application JP 2006-263217, filed September 27, 2006, Japanese Patent application JP 2006-263359, filed September 27, 2006, and Japanese Patent application JP 2006-263360, filed September 27, 2006.

## Claims

1. A lithographic printing plate precursor comprising a protective layer containing as a main component, a polymer containing as a repeating unit, 90% by mole or more of acrylonitrile.

2. The lithographic printing plate precursor of Claim 1, wherein the polymer is a latex.

3. The lithographic printing plate precursor of Claim 2, wherein an average particle size of the latex is 3 mm or less.

4. The lithographic printing plate precursor of any one of Claims 1-3, wherein the protective layer contains mica.

5. The lithographic printing plate precursor of any one of Claims 1-4, which comprises an image-recording layer containing a radical generator, a sensitizing dye and a compound having at least one addition-polymerizable ethylenically unsaturated bond.

6. The lithographic printing plate precursor of Claim 5, wherein the sensitizing dye is an infrared absorbing agent.

7. The lithographic printing plate precursor of Claim 5 or 6, wherein the image-recording layer is a layer capable of being removed with at least one of printing ink and dampening water.

8. The lithographic printing plate precursor of any one of Claims 5-7, wherein the image-recording layer further contains a microcapsule or microgel.

9. The lithographic printing plate precursor of any one of Claims 5-8, which comprises a support and an image-recording layer capable of being image-recorded with infrared laser exposure and which is capable of performing printing by conducting image-recording with an infrared laser and mounting on a printing machine without carrying out a development processing or by mounting on a printing machine and conducting image-recording with an infrared laser.

10. A lithographic printing method comprising: a step of exposing imagewise the lithographic printing plate precursor of any one of Claims 5-9 with an infrared laser and a printing step by supplying oily ink and an aqueous component to perform printing without carrying out any development processing of the exposed lithographic printing plate precursor, wherein an unexposed area of the lithographic printing plate precursor to the infrared laser is removed in the course of the printing step.

## Patentansprüche

1. Lithografiedruckplattenvorläufer, umfassend eine Schutzschicht, die als eine Hauptkomponente ein Polymer umfasst, welches als eine Wiederholungseinheit 90 Mol% oder mehr Acrylnitril umfasst.

2. Lithografiedruckplattenvorläufer gemäß Anspruch 1, worin das Polymer ein Latex ist.

3. Lithografiedruckplattenvorläufer gemäß Anspruch 2, worin die mittlere Partikelgröße des Latex 3 mm oder kleiner ist.

4. Lithografiedruckplattenvorläufer gemäß irgendeinem der Ansprüche 1 bis 3, worin die Schutzschicht Glimmer enthält.

5. Lithografiedruckplattenvorläufer gemäß irgendeinem der Ansprüche 1 bis 4 , welcher eine Bildaufzeichnungsschicht umfasst, die einen Radikalbildner, einen Sensibilisierungsfarbstoff und eine Verbindung enthält, die mindestens eine additionspolymerisierbare, ethylenisch ungesättigte Bindung aufweist.

6. Lithografiedruckplattenvorläufer gemäß Anspruch 5, worin der Sensibilisierungsfarbstoffe ein Infrarotabsorber ist.

7. Lithografiedruckplattenvorläufer gemäß Anspruch 5 oder 6, worin die Bildaufzeichnungsschicht eine Schicht ist, die mit mindestens einem von Drucktinte und Anfeuchtwasser entfernt werden kann.

8. Lithografiedruckplattenvorläufer gemäß irgendeinem der Ansprüche 5 bis 7, worin die Bildaufzeichnungsschicht ferner eine Mikrokapsel oder Mikrogel enthält.

9. Lithografiedruckplattenvorläufer gemäß irgendeinem der Ansprüche 5 bis 8, welcher einen Träger und eine Bildaufzeichnungsschicht, mit der durch Infrarotlaserbelichtung ein Bild aufgezeichnet werden kann, umfasst und mit dem man das Drucken durch Durchführen einer Bildaufzeichnung mit einem Infrarotlaser und Montieren auf einer Druckmaschine ohne Durchführen einer Entwicklungsverarbeitung, oder durch Montieren auf einer Druckmaschine und Durchführen der Bildaufzeichnung mit einem Infrarotlaser durchführen kann.

10. Lithografisches Druckverfahren, umfassend: einen Schritt zum bildweisen Belichten des Lithografiedruckplattenvorläufer gemäß irgendeinem der Ansprüche 5 bis 9 mit einem Infrarotlaser und einen Druckschritt durch Zuführen einer öligen Tinte und einer wässrigen Komponente, um das Drucken durchzuführen, ohne irgendeine Entwicklungsverarbeitung des belichteten Lithografiedruckplattenvorläufers durchzuführen, worin ein nicht dem Infrarotlaser ausgesetzter Bereich des Lithografiedruckplattenvorläufers im Verlauf des Druckschritts entfernt wird.

## Revendications

1. Précurseur de plaque d'impression lithographique comprenant une couche protectrice contenant, en tant que composant principal, un polymère contenant, en tant qu'unité de répétition, 90 % en mole ou plus d'acrylonitrile.

2. Précurseur de plaque d'impression lithographique selon la revendication 1, dans lequel le polymère est un latex.

3. Précurseur de plaque d'impression lithographique selon la revendication 2, dans lequel une taille de particule moyenne du latex est de 3 mm ou moins.

4. Précurseur de plaque d'impression lithographique selon l'une quelconque des revendications 1 à 3, dans lequel la couche protectrice contient du mica.

5. Précurseur de plaque d'impression lithographique selon l'une quelconque des revendications 1 à 4, qui comprend une couche d'enregistrement d'image contenant un générateur de radical, une teinture sensibilisante et un composé ayant au moins une liaison non saturée en ce qui concerne l'éthylène polymérisable par addition.

6. Précurseur de plaque d'impression lithographique selon la revendication 5, dans lequel la teinture sensibilisante est un agent absorbant de l'infrarouge.

7. Précurseur de plaque d'impression lithographique selon la revendication 5 ou 6, dans lequel la couche d'enregistrement d'image est une couche capable d'être enlevée par au moins l'une d'encre d'impression et d'eau de mouillage.

8. Précurseur de plaque d'impression lithographique selon l'une quelconque des revendications 5 à 7, dans lequel la couche d'enregistrement d'image contient en outre une microcapsule ou un microgel.

9. Précurseur de plaque d'impression lithographique selon l'une quelconque des revendications 5 à 8, qui comprend un support et une couche d'enregistrement d'image capable de subir un enregistrement d'image par une exposition au laser infrarouge et qui est capable d'effectuer une impression en effectuant un enregistrement d'image avec un laser infrarouge et par montage sur une machine d'impression sans effectuer de traitement de développement ou par montage sur une machine d'impression et en effectuant un enregistrement d'image avec un laser infrarouge.

10. Procédé d'impression lithographique comprenant : une étape d'exposition image par image le précurseur de plaque d'impression lithographique selon l'une quelconque des revendications 5 à 9 avec un laser infrarouge et une étape d'impression en fournissant de l'encre huileuse et un composant aqueux pour effectuer une impression sans effectuer de quelconque traitement de développement du précurseur de plaque d'impression lithographique exposé, dans lequel une zone non exposée du précurseur de plaque d'impression lithographique au laser infrarouge est enlevée au cours de l'étape d'impression.
